(19) Europäisches Patentamt
European Patent Office
Office européen des brevets

(11) EP 2 406 686 B1

(12) **EUROPEAN PATENT SPECIFICATION**

(45) Date of publication and mention of the grant of the patent:
**04.12.2013 Bulletin 2013/49**

(21) Application number: **10750956.4**

(22) Date of filing: **12.03.2010**

(51) Int Cl.:
***G03F 7/039*** *(2006.01)* ***C08F 12/22*** *(2006.01)*
***G03F 7/004*** *(2006.01)* ***H01L 21/027*** *(2006.01)*

(86) International application number:
**PCT/JP2010/054727**

(87) International publication number:
**WO 2010/104218 (16.09.2010 Gazette 2010/37)**

(54) **RADIATION SENSITIVE RESIN COMPOSITION AND METHOD OF FORMING PATTERN USING THE COMPOSITION**

STRAHLUNGSEMPFINDLICHE HARZZUSAMMENSETZUNG UND STRUKTURBILDUNGSVERFAHREN MITHILFE DER ZUSAMMENSETZUNG

COMPOSITION DE RÉSINE SENSIBLE AU RAYONNEMENT ET PROCÉDÉ DE FORMATION D'UN MOTIF UTILISANT LA COMPOSITION

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.03.2009 JP 2009061923**

(43) Date of publication of application:
**18.01.2012 Bulletin 2012/03**

(73) Proprietor: **FUJIFILM Corporation**
**Tokyo 106-8620 (JP)**

(72) Inventors:
- **TSUBAKI, Hideaki**
**Shizuoka-ken (JP)**
- **SHIRAKAWA, Koji**
**Shizuoka-ken (JP)**
- **YATSUO, Tadateru**
**Shizuoka-ken (JP)**
- **TSUCHIHASHI, Toru**
**Shizuoka-ken (JP)**
- **TSUCHIMURA, Tomotaka**
**Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A2- 1 536 285** **WO-A1-2010/035905**
**JP-A- 2000 187 330** **JP-A- 2000 267 282**
**JP-A- 2002 202 608** **JP-A- 2002 333 713**
**JP-A- 2008 249 890** **JP-A- 2008 268 931**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 406 686 B1

## Description

### Technical Field

The present invention relates to an actinic-ray-or radiation-sensitive resin composition suitable for use in an ultramicrolithography process or other photofabrication process for production of very-large-scale integrated circuits or large-capacity microchips, etc. More particularly, the present invention relates to an actinic-ray- or radiation-sensitive resin composition capable of forming a highly fined pattern with the use of electron beams, EUV light or the like, especially an actinic-ray- or radiation-sensitive resin composition suitable for use in the microfabrication of semiconductor devices using electron beams or EUV light, and relates to a method of forming a pattern with the use of the composition.

In the present invention, the terms "actinic rays" and "radiation" mean, for example, brightline spectra from a mercury lamp, far ultraviolet represented by excimer laser, extreme ultraviolet, X-rays, electron beams and the like. In the present invention, the term "light" means actinic rays or radiation.

### Background Art

In the production process for semiconductor devices, such as ICs and LSIs, it is conventional practice to perform microfabrication by lithography using a photoresist composition. In recent years, the formation of an ultrafine pattern in the submicron region or quarter-micron region is increasingly demanded in accordance with the realization of high integration for integrated circuits. Accordingly, the trend of exposure wavelength toward a short wavelength, for example, from g-rays to i-rays and further to KrF excimer laser light is seen. Moreover, the development of lithography using electron beams, X-rays or EUV light besides excimer laser light is now progressing.

The lithography using electron beams or EUV light is positioned as the next-generation or next-next-generation pattern forming technology. Various resins and acid generators therefor have been developed.

With respect to the resins, when a KrF excimer laser is used as an exposure light source, a resin whose fundamental skeleton consists of a poly(hydroxystyrene) exhibiting a low absorption mainly in the region of 248 nm is employed as a major component. When an ArF excimer laser (193 nm) is used as an exposure light source, as the compounds having an aromatic group inherently exhibit a sharp absorption in the region of 193 nm, resists for ArF excimer laser containing a highly transparent resin having an alicyclic hydrocarbon structure have been developed. When electron beams or EUV light is used as an exposure light source, both of the above resins for KrF excimer laser and ArF excimer laser are used.

WO 2010/035905 A1, document in the sense of Art.54(3) EPC, discloses an actinic-ray- or radiation-sensitive resin composition comprising the acid generator of formula (I) wherein B is a cycloaliphatic group or a noncyclic hydrocarbon and (B) a resin that is decomposed by the action of an acid to thereby exhibit an increased solubility in an alkali developer. Examplified is the following resin:

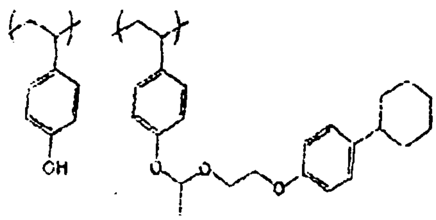

EP-A-1536285, JP-A-2008249890 and JP-A-2000267282 disclose a photosensitive composition comprising an acid generator that produces sulfonic acid by irradiation with actinic rays or a radiation and resin capable of decomposing under the action of an acid to increase the solubility of the resin in an alkali developer.

With respect to the acid generators, using a triphenylsulfonium salt is generally known (see, for example, patent reference 1).

It is common practice to select an appropriate combination of resin, photoacid generator, additives, solvent, etc. for use in a resist from the viewpoint of the overall performance of the resist. However, the current situation is that it is extremely difficult to find such an appropriate combination. Further, in the lithography using electron beams, X-rays or EUV light, it is demanded to resolve the problem of development residue that might cause a defect in the manufacturing of a photomask or a device.

Moreover, when use is made of, for example, a light source capable of emitting electron beams, X-rays or EUV light, the exposure is carried out in vacuum. This might cause any low-boiling-point compounds, such as solvents, and resist materials decomposed by high energy to evaporate to thereby dirty the exposure apparatus. This outgassing problem is attracting greater attention. In recent years, various researches have been conducted toward the reduction

of the outgassing. The researches include a proposal to inhibit the evaporation of low-molecular compounds by providing a top coat layer (see, for example, patent reference 2) and other various proposals. With respect to the resins and acid generators as well, an ingenuity for the reduction of outgassing is demanded.

[Prior Art References]

Patent reference 1: Jpn. Pat. Appln. KOKAI Publication No. (hereinafter referred to as JP-A-) H10-282669, and
Patent reference 2: USP No. 6,548,221.

Disclosure of Invention

It is an object of the present invention to provide an actinic-ray- or radiation-sensitive resin composition that excels in development residue and outgassing performance. It is another object of the present invention to provide a method of forming a pattern with the use of the composition.
The above objects can be attained by the present invention. Some aspects of the present invention is as follows.

[1] An actinic-ray- or radiation-sensitive resin composition as claimed in claim 1. An embodiment thereof is defined in present claim 2.
[3] A method of forming a pattern, comprising forming the actinic-ray- or radiation-sensitive resin composition according to any of [1] into a film, exposing the film and developing the exposed film.
[4] The pattern forming method according to [3], wherein the exposure is carried out using X-rays, electron beams or EUV light.

The present invention has made it feasible to provide an actinic-ray- or radiation-sensitive resin composition that excels in development residue and outgassing performance and to provide a method of forming a pattern with the use of the composition.

Best Mode for Carrying Out the Invention

The present invention will be described in detail below.
With respect to the expression of a group (atomic group) used in this specification, the expression even when there is no mention of "substituted and unsubstituted" encompasses groups not only having no substituent but also having substituents. For example, the expression "alkyl groups" encompasses not only alkyls having no substituent (unsubstituted alkyls) but also alkyls having substituents (substituted alkyls).
In the present invention, the expression "development residue" refers to any aggregate of resist composition adhering to, upon the formation of a line-and-space pattern, the space area and the top and sides of the line area.
The present invention is based on the finding of a specific combination of any of the compounds of above General Formula (I) (hereinafter also referred to as "acid generator (A1)") as a compound that generates an acid when exposed to actinic rays or radiation effective for an actinic-ray- or radiation-sensitive resin composition (acid generator) with a resin (hereinafter also referred to as "resin (B)") that has the residue (c) of a compound having an ionization potential value lower than that of phenol and when acted on by an acid, exhibits an increased solubility in alkali.
The actinic-ray- or radiation-sensitive resin composition according to the present invention contains the acid generator (A1) and the resin (B) and optionally further a basic compound (E), etc.

[1] Compounds of General Formula (I) (acid generators (A1))

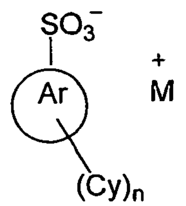

(I)

In the formula, Ar represents an aromatic ring having Cy groups and optionally further other substituents,

n is an integer of 2 or greater,
Cy represents a group having a substituted or unsubstituted cycloaliphatic group, provided that a plurality of Cy groups

may be identical with or different from each other, and

$M^+$ represents an organic onium ion.

The aromatic ring represented by Ar is preferably an aromatic ring having 6 to 30 carbon atoms. The aromatic ring has Cy groups and optionally further other substituents.

As the aromatic ring, there can be mentioned, for example, a benzene ring, a naphthalene ring, a pentalene ring, an indene ring, an azulene ring, a heptalene ring, an indecene ring, a perylene ring, a pentacene ring, an acenaphthalene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an iodolizine ring, an indole ring, a benzofuran ring, a benzothiophene ring, an isobenzofuran ring, a quinolizine ring, a quinoline ring a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, a phenazine ring or the like. Of these, a benzene ring, a naphthalene ring and an anthracene ring are preferred from the viewpoint of the simultaneous attainment of roughness improvement and sensitivity enhancement. A benzene ring is more preferred.

The aromatic ring may further have a substituent other than Cy groups. As the substituent, there can be mentioned, for example, a halogen group such as a fluorine atom, a chlorine atom, a bromine atom or an iodine atom, an alkoxy group such as a methoxy group, an ethoxy group or a tert-butoxy group, an aryloxy group such as a phenoxy group or a p-tolyloxy group, an alkylthioxy group such as a methylthioxy group, an ethylthioxy group or a tert-butylthioxy group, an arylthioxy group such as a phenylthioxy group or a p-tolylthioxy group, an alkoxycarbonyl group such as a methoxycarbonyl group or a butoxycarbonyl group, an aryloxycarbonyl group such as a phenoxycarbonyl group or a p-tolyloxycarbonyl group, an alkenyl group such as a vinyl group, a propenyl group or a hexenyl group, an alkynyl group such as an acetylene group, a propynyl group or a hexynyl group, an aryl group such as a phenyl group or a tolyl group, a hydroxyl group, a carboxyl group, a sulfonate group or the like.

The group having a substituted or unsubstituted cycloaliphatic group, represented by Cy is a substituted or unsubstituted cycloaliphatic group bonded directly or via a bivalent connecting group to the aromatic ring represented by Ar.

As the bivalent connecting group, there can be mentioned, for example, a member or combination of two or more members selected from the group consisting of an alkylene group, -O-, -S-, -C(=O)- and -C(=O)O-.

As the cycloaliphatic group, there can be mentioned a cycloalkyl group such as a cyclopropyl group, a cyclobutyl group, a cyclopentyl group, a cyclohexyl group, a cycloheptyl group or a cyclooctyl group, an adamantyl group, a norbornyl group, a bornyl group, a camphenyl group, a decahydronaphthyl group, a tricyclodecanyl group, a tetracyclodecanyl group, a camphoroyl group, a dicyclohexyl group, a pinenyl group or the like. The cycloaliphatic group may have a substituent.

When the above cycloaliphatic group has a substituent, as the substituent, there can be mentioned, for example, a halogen group such as a fluorine atom, a chlorine atom, a bromine atom or an iodine atom, an alkoxy group such as a methoxy group, an ethoxy group or a tert-butoxy group, an aryloxy group such as a phenoxy group or a p-tolyloxy group, an alkylthioxy group such as a methylthioxy group, an ethylthioxy group or a tert-butylthioxy group, an arylthioxy group such as a phenylthioxy group or a p-tolylthioxy group, an alkoxycarbonyl group such as a methoxycarbonyl group or a butoxycarbonyl group, a phenoxycarbonyl group, an acetoxy group, a linear alkyl group such as a methyl group, an ethyl group, a propyl group, a butyl group, a heptyl group, a hexyl group, a dodecyl group or a 2-ethylhexyl group, a branched alkyl group, a cycloalkyl group such as a cyclohexyl group, an alkenyl group such as a vinyl group, a propenyl group or a hexenyl group, an alkynyl group such as an acetylene group, a propynyl group or a hexynyl group, an aryl group such as a phenyl group or a tolyl group, a hydroxyl group, a carboxyl group, a sulfonate group, a carbonyl group or the like. Of these, the linear alkyl group and the branched alkyl group are preferred from the viewpoint of the simultaneous resolution of development residue and outgassing performance.

Particular examples of these groups having an cycloaliphatic group are shown below.

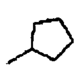 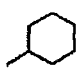 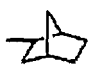 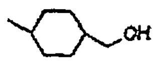

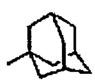 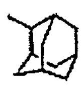 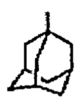 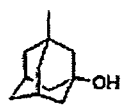 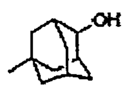 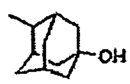

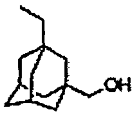 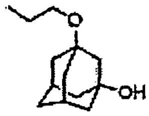 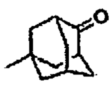 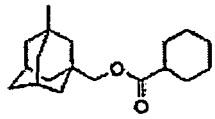 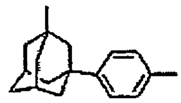

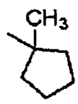 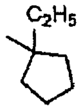 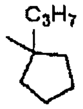 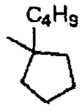 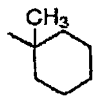 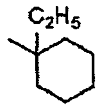 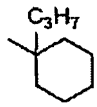 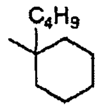

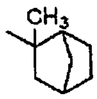 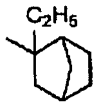 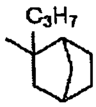 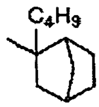 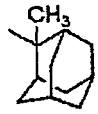 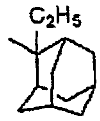 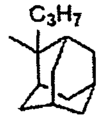 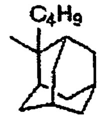

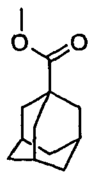 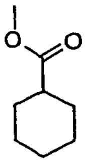 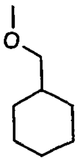 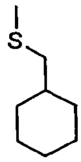

Among the above cycloaliphatic groups, a cycloalkyl group, an adamantyl group and a norbornyl group are preferred from the viewpoint of the simultaneous resolution of development residue and outgassing performance. A cycloalkyl group, an adamantyl group and a norbornyl group are more preferred, and a cycloalkyl group is further more preferred. Among various cycloalkyl groups, a cyclohexyl group is most preferred.

In the formula, n is an integer of 2 or greater. From the viewpoint of the simultaneous resolution of development residue and outgassing performance, 2 to 5 are preferred, 2 to 4 are more preferred, and n=3 is most preferred.

With respect to the Cy groups, from the viewpoint of the resolution of development residue, it is preferred to introduce a substituent in at least one o-position of a sulfonate anion. More preferably, substituents are introduced in two o-positions of a sulfonate anion.

The following sulfonate anions can be used in General Formula (I).

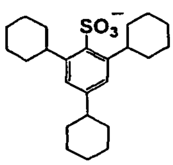
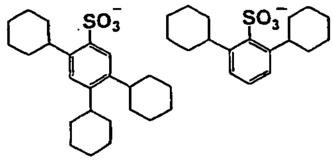
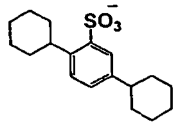
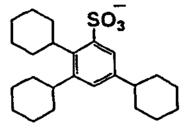

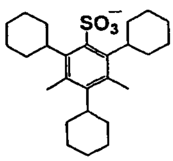
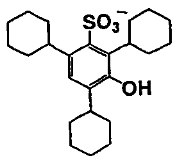
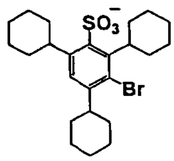
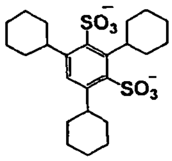
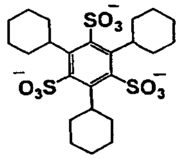

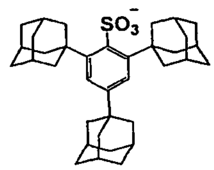
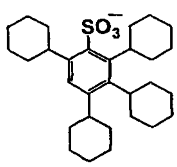
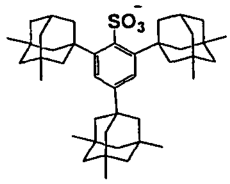
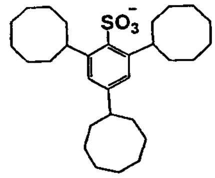
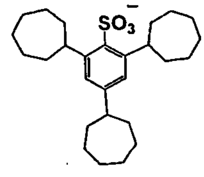

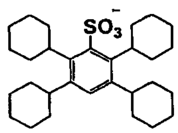
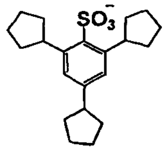
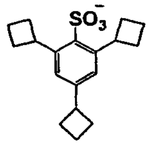
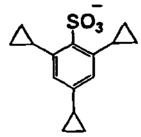
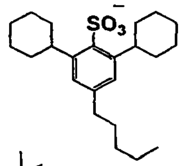

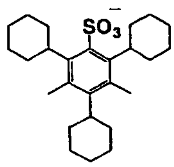
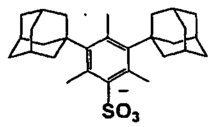
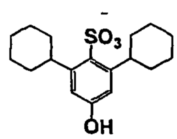
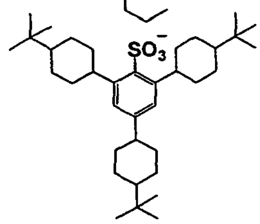

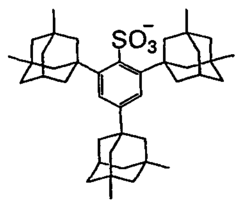
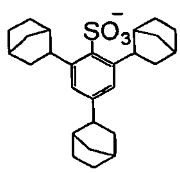
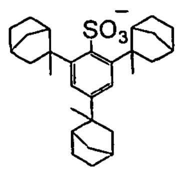
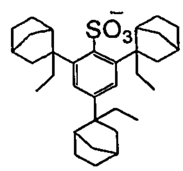
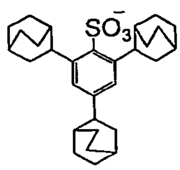

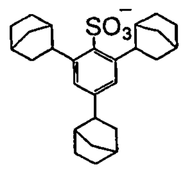
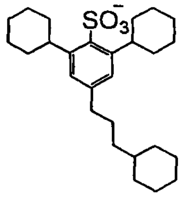
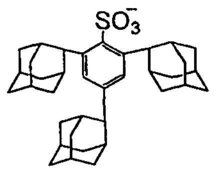
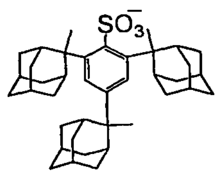
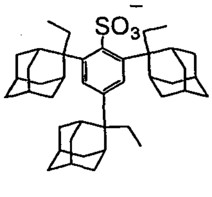

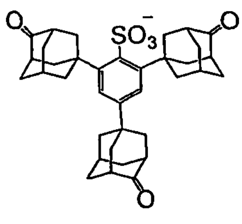
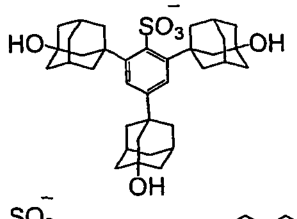
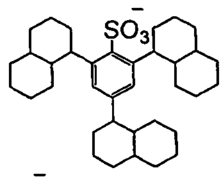
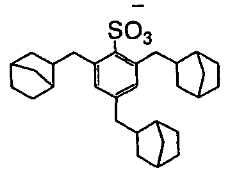

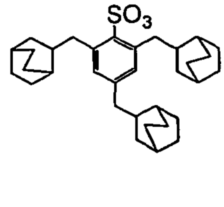
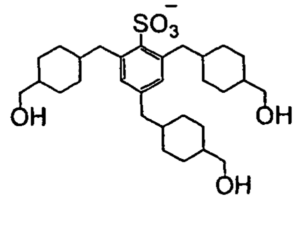

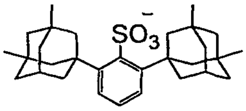
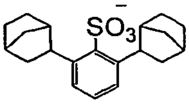
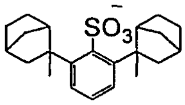
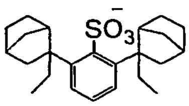
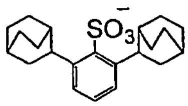
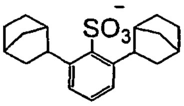
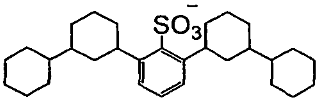
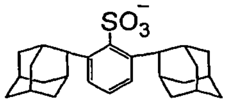
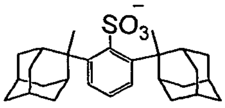
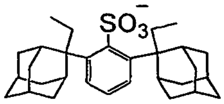
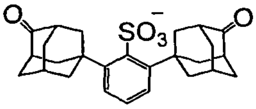
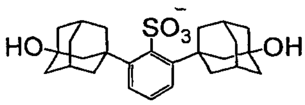
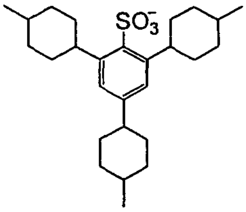
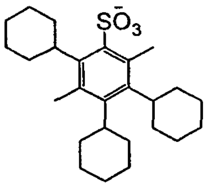
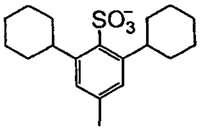
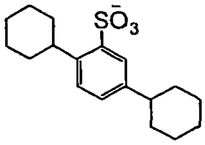
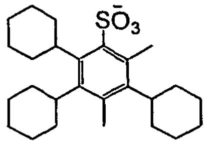
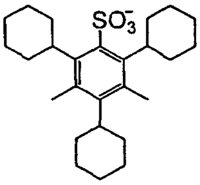
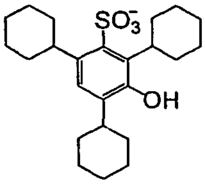
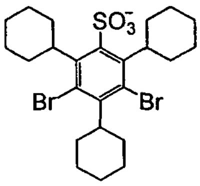
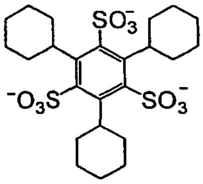
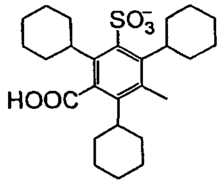
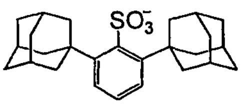
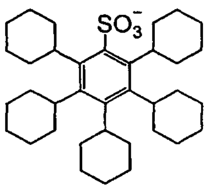
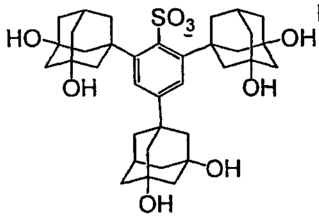
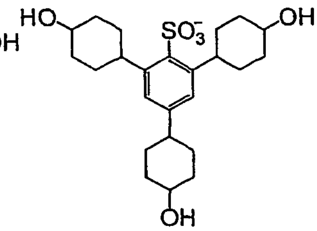
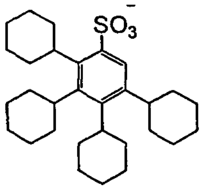
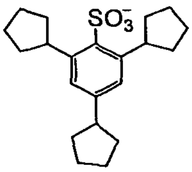
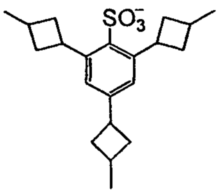
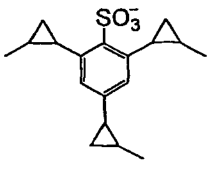
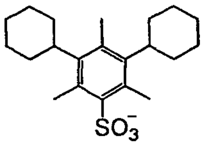
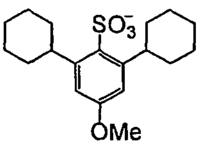
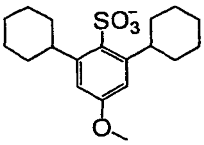
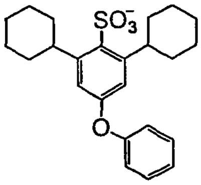
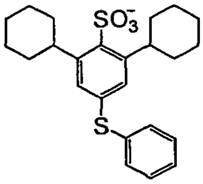
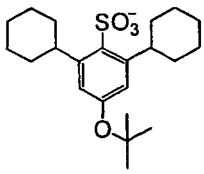

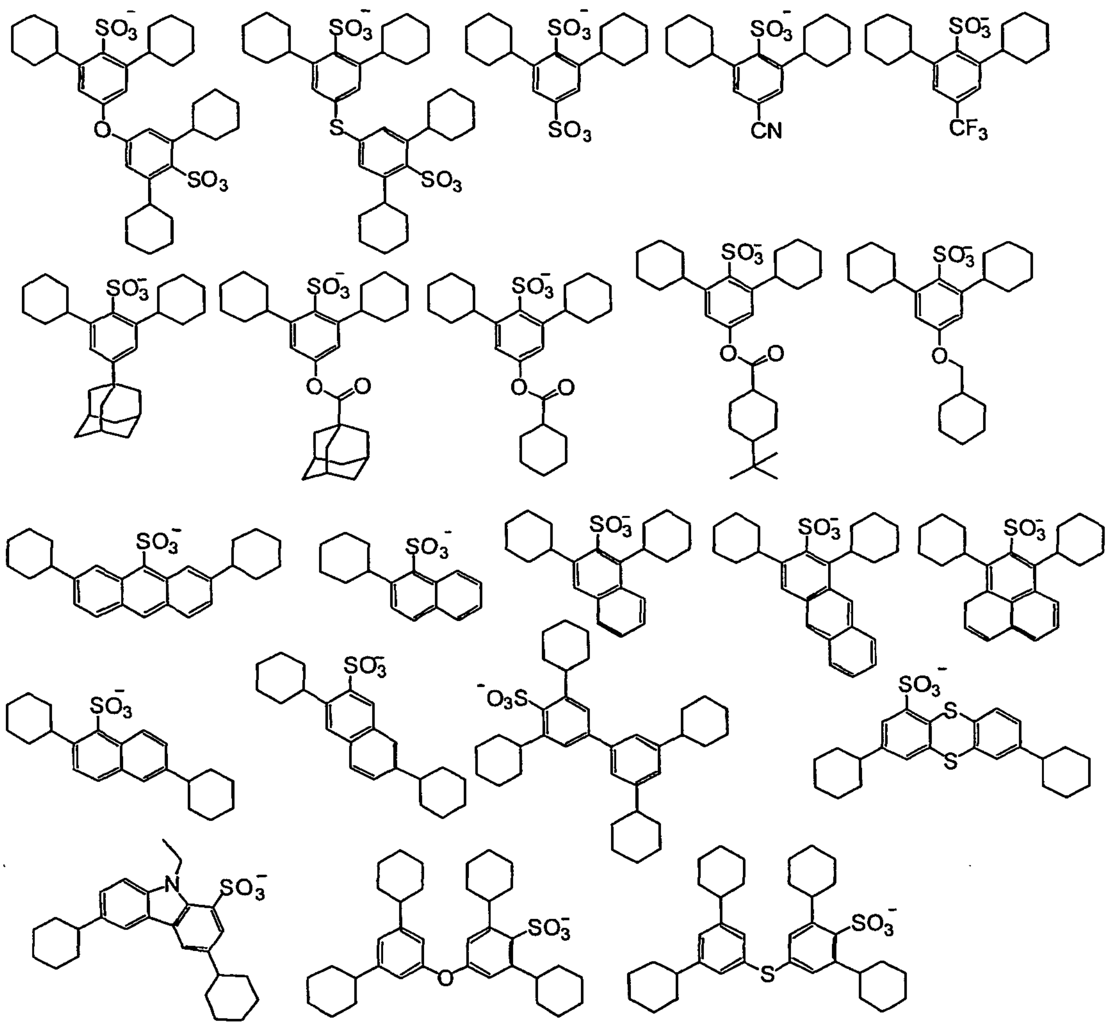

As preferred organic onium ions (counter cations) represented by $M^+$, there can be mentioned, for example, onium ions, such as iodonium, sulfonium, phosphonium, diazonium, ammonium, pyridinium, quinolinium, acridinium, oxonium, selenonium and arsonium. Among these, onium ions, such as iodonium, sulfonium, phosphonium, diazonium, quinolinium and acridinium, are preferred.

As preferred counter cations, there can be mentioned, for example, the cations having the structures of Formulae (VII) and (VIII) below.

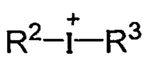

(VII)

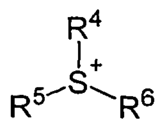

(VIII)

In Formulae (VII) and (VIII), each of $R^2$ and $R^3$ independently represents an aryl group. Each of $R^4$ to $R^6$ independently represents an alkyl group, an alkenyl group, an alkynyl group, an aryl group, a cyclohydrocarbon group or a heterocyclic group.

Each of the alkyl groups represented by $R^4$ to $R^6$ preferably has 1 to 30 carbon atoms, more preferably 1 to 20 carbon atoms and further preferably 1 to 8 carbon atoms. The alkyl groups may be linear or may have a substituent.

Each of the alkenyl groups represented by $R^4$ to $R^6$ preferably has 2 to 30 carbon atoms, more preferably 2 to 20 carbon atoms and further preferably 2 to 8 carbon atoms. The alkenyl groups may have a substituent.

Each of the alkynyl groups represented by $R^4$ to $R^6$ preferably has 2 to 30 carbon atoms, more preferably 2 to

20 carbon atoms and further preferably 2 to 8 carbon atoms. The alkynyl groups may have a substituent.

Each of the aryl groups represented by $R^2$ to $R^6$ preferably has 6 to 30 carbon atoms, more preferably 6 to 20 carbon atoms and further preferably 6 to 10 carbon atoms. The aryl groups may have a substituent.

Each of the cyclohydrocarbon groups represented by $R^4$ to $R^6$ preferably has 3 to 30 carbon atoms, more preferably 3 to 20 carbon atoms and further preferably 3 to 10 carbon atoms. The cyclohydrocarbon groups may have a substituent.

Each of the heterocyclic groups represented by $R^4$ to $R^6$ preferably has 4 to 30 carbon atoms, more preferably 4 to 20 carbon atoms and further preferably 4 to 10 carbon atoms. The heterocyclic groups may have a substituent. Preferably, the heteroatom contained in the heterocyclic groups is a nitrogen atom, an oxygen atom or a sulfur atom.

In the formula (VII), if appropriate, $R^2$ and $R^3$ may be bonded to each other to thereby form a ring.

In the formula (VIII), if appropriate, two or more of $R^4$ to $R^6$ may be bonded to each other to thereby form a ring.

The substituent that may be introduced in any of the above alkyl group, alkenyl group, alkynyl group, aryl group, cyclohydrocarbon group or heterocyclic group may be any of monovalent nonmetallic atomic groups excluding hydrogen. Preferred examples of the monovalent nonmetallic atomic groups include a halogen atom (-F, -Br, -Cl or -I), a hydroxyl group, an alkyl group, an aryl group, an alkenyl group, an alkynyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group or its conjugate base group (hereinafter referred to as "carboxylate"), an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) or its conjugate base group (hereinafter referred to as "sulfonate group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group or its conjugate base group, an N-alkylsulfonylsulfamoyl group ($-SO_2NHSO_2$(alkyl or its conjugate base group, an N-arylsulfonylsulfamoyl group ($-SO_2NHSO_2$(aryl)) or its conjugate base group, an N-alkylsulfonylcarbamoyl group ($-CONHSO_2$(alkyl)) or its conjugate base group, an N-arylsulfonylcarbamoyl group ($-CONHSO_2$(aryl)) or its conjugate base group, a silyl group, an alkoxysilyl group (-Si(Oalkyl)$_3$), an aryloxysilyl group (-Si(Oaryl)$_3$), a hydroxysilyl group ($-Si(OH)_3$) or its conjugate base group, a phosphono group ($-PO_3H_2$) or its conjugate base group (hereinafter referred to as "phosphonate group"), a dialkylphosphono group ($-PO_3$(alkyl)$_2$), a diarylphosphono group ($-PO_3$(aryl)$_2$), an alkylarylphosphono group ($-PO_3$(alkyl) (aryl)), a monoalkylphosphono group ($-PO_3H$(alkyl)) or its conjugate base group (hereinafter referred to as "alkylphosphonate group"), a monoarylphosphono group ($-PO_3H$(aryl)) or its conjugate base group (hereinafter referred to as "arylphosphonate group"), a phosphonooxy group ($-OPO_3H_2$) or its conjugate base group (hereinafter referred to as "phosphonateoxy group"), a dialkylphosphonooxy group ($-OPO_3$(alkyl)$_2$), a diarylphosphonooxy group ($-OPO_3$(aryl)$_2$), an alkylarylphosphonooxy group ($-OPO_3$(alkyl) (aryl)), a monoalkylphosphonooxy group ($-OPO_3H$(alkyl)) or its conjugate base group (hereinafter referred to as "alkylphosphonateoxy group"), a monoarylphosphonooxy group ($-OPO_3H$(aryl)) or its conjugate base group (hereinafter referred to as "arylphosphonateoxy group"), a cyano group and a nitro group. These substituents may further be substituted with these substituents. Moreover, if appropriate, these substituents may form rings.

As preferred particular examples of the counter cations of General Formulae (VII) and (VIII), there can be mentioned, for example, those of the structures of formulae Ca-1 to Ca-33 below.

Ca - 1
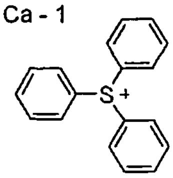
Ca - 2
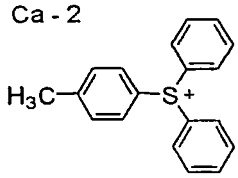
Ca - 3
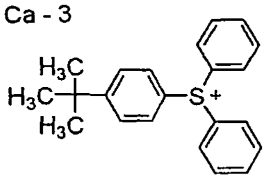

Ca - 4
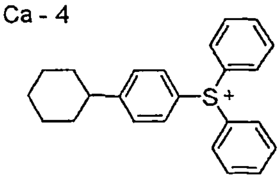
Ca - 5
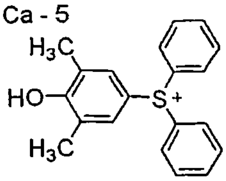
Ca - 6
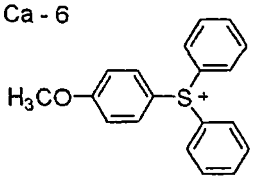

Ca - 7
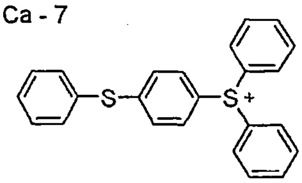
Ca - 8
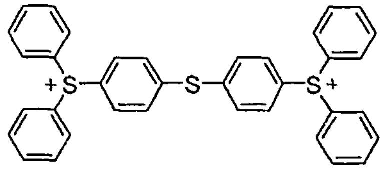

Ca - 9
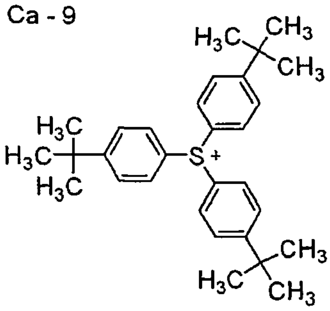
Ca - 10
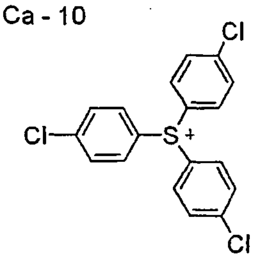
Ca - 11
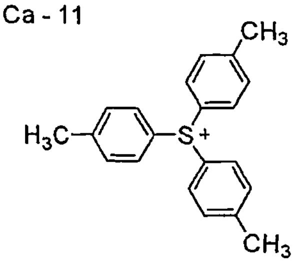

Ca - 12
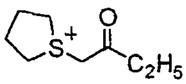
Ca - 13
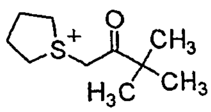
Ca - 14
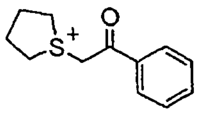
Ca - 15
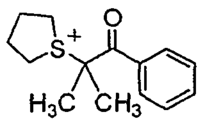

Ca - 16
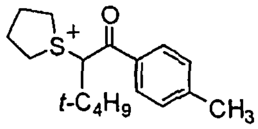
Ca - 17
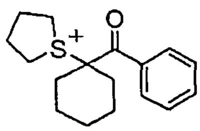
Ca - 18
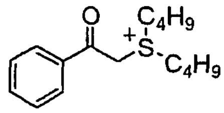
Ca - 19
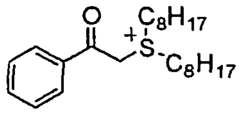

Ca - 20

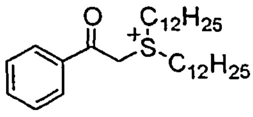

Ca - 21

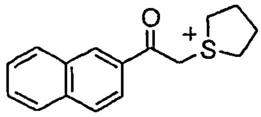

Ca - 22

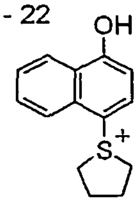

Ca - 23

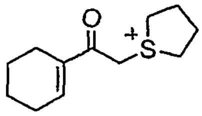

Ca - 24

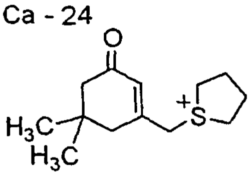

Ca - 25

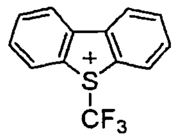

Ca - 26

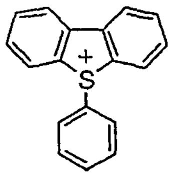

Ca - 27

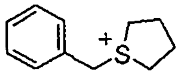

Ca - 28

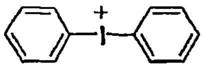

Ca - 29

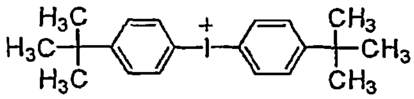

Ca - 30

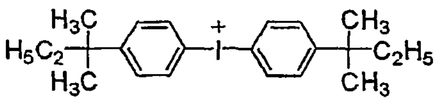

Ca - 31

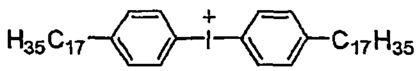

Ca - 32

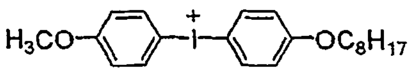

Ca - 33

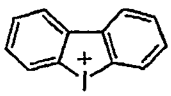

Furthermore, as organic onium ions preferred from the viewpoint of outgas suppression, there can be mentioned the cations having the structures of General Formula (IX) below.

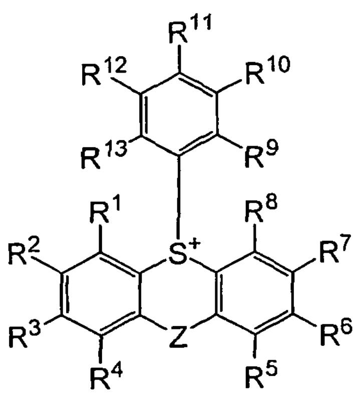

(IX)

In General Formula (IX),
each of $R^1$ to $R^{13}$ independently represents a hydrogen atom or a substituent, provided that at least one of $R^1$ to $R^{13}$ is a substituent containing an alcoholic hydroxyl group.

Z represents a single bond or a bivalent connecting group.

In the present invention, the alcoholic hydroxyl group refers to a hydroxyl group bonded to a carbon atom of an alkyl group.

When $R^1$ to $R^{13}$ represent substituents containing an alcoholic hydroxyl group, it is preferred for the $R^1$ to $R^{13}$ to represent the groups of the formula -W-Y, wherein Y represents a hydroxyl-substituted alkyl group and W represents a single bond or a bivalent connecting group.

As the alkyl group represented by Y, there can be mentioned a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group, a boronyl group or the like. Of these, an ethyl group, a propyl group, an isopropyl group, an n-butyl group, an isobutyl group and a sec-butyl group are preferred. An ethyl group, a propyl group and an isopropyl group are more preferred. Especially preferably, Y contains the structure of $-CH_2CH_2OH$.

The bivalent connecting group represented by W is not particularly limited. For example, as the bivalent connecting group, there can be mentioned a bivalent group as obtained by replacing with a single bond any hydrogen atom of a monovalent group, such as an alkoxy group, an acyloxy group, a carbamoyloxy group, an alkoxycarbonyloxy group, an aryloxycarbonyloxy group, an acylamino group, an aminocarbonylamino group, an alkoxycarbonylamino group, an aryloxycarbonylamino group, a sulfamoylamino group, an alkyl- or arylsulfonylamino group, an alkylthio group, an arylthio group, a sulfamoyl group, an alkyl- or arylsulfinyl group, an alkyl- or arylsulfonyl group, an acyl group, an aryloxycarbonyl group, an alkoxycarbonyl group or a carbamoyl group.

W is preferably a single bond, or a bivalent group as obtained by replacing with a single bond any hydrogen atom of a group selected from among an alkoxy group, an acyloxy group, an acylamino group, an alkyl-or arylsulfonylamino group, an alkylthio group, an alkylsulfonyl group, an acyl group, an alkoxycarbonyl group and a carbamoyl group. More preferably, W is a single bond, or a bivalent group as obtained by replacing with a single bond any hydrogen atom of a group selected from among an acyloxy group, an alkylsulfonyl group, an acyl group and an alkoxycarbonyl group.

When $R^1$ to $R^{13}$ represent substituents containing an alcoholic hydroxyl group, the number of carbon atoms contained in each of the substituents is preferably in the range of 2 to 10, more preferably 2 to 6 and further preferably 2 to 4.

Each of the substituents containing an alcoholic hydroxyl group represented by $R^1$ to $R^{13}$ may have two or more alcoholic hydroxyl groups. The number of alcoholic hydroxyl groups contained in each of the substituents containing an alcoholic hydroxyl group represented by $R^1$ to $R^{13}$ is in the range of 1 to 6, preferably 1 to 3 and more preferably 1.

The number of alcoholic hydroxyl groups contained in any of the compounds of General Formula (IX) as the total of those of $R^1$ to $R^{13}$ is in the range of 1 to 10, preferably 1 to 6 and more preferably 1 to 3.

When $R^1$ to $R^{13}$ do not contain any alcoholic hydroxyl group, each of $R^1$ to $R^{13}$ independently represents a hydrogen atom or a substituent. The substituent is not particularly limited. For example, as the substituent, there can be mentioned a halogen atom, any of alkyl groups (including a cycloalkyl group, a bicycloalkyl group and a tricycloalkyl group), any of alkenyl groups (including a cycloalkenyl group and a bicycloalkenyl group), an alkynyl group, an aryl group, a heterocyclic group, a cyano group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, any of amino groups (including an anilino group), an ammonio group, an acylamino group, an aminocarbonylamino group, an alkoxycarbonylamino group, an aryloxycarbonylamino group, a sulfamoylamino group, an alkyl- or arylsulfonylamino group, a mercapto group, an alkylthio group, an arylthio group, a heterocyclic thio group, a sulfamoyl group, a sulfo group, an alkyl-or arylsulfinyl group, an alkyl- or arylsulfonyl group, an acyl group, an aryloxycarbonyl group, an alkoxycarbonyl group, a carbamoyl group, an aryl- or heterocyclic azo group, an imido group, a phosphino group, a phosphinyl group, a phosphinyloxy group, a phosphinylamino group, a phosphono group, a silyl group, a hydrazino group, a ureido group, a boronic acid residue ($-B(OH)_2$), a phosphato group ($-OPO(OH)_2$), a sulfato group ($-OSO_3H$) or any of other substituents known in the art.

Any two adjacent to each other of $R^1$ to $R^{13}$ can cooperate with each other so as to form a ring (an aromatic or nonaromatic cyclohydrocarbon or heterocycle which can form a condensed polycycle through further combination; as such, there can be mentioned, for example, a benzene ring, a naphthalene ring, an anthracene ring, a phenanthrene ring, a fluorene ring, a triphenylene ring, a naphthacene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring or a phenazine ring).

When $R^1$ to $R^{13}$ do not contain any alcoholic hydroxyl group, each of $R^1$ to $R^{13}$ preferably represents a hydrogen atom, a halogen atom, any of alkyl groups (including a cycloalkyl group, a bicycloalkyl group and a tricycloalkyl group),

any of alkenyl groups (including a cycloalkenyl group and a bicycloalkenyl group), an alkynyl group, an aryl group, a cyano group, a carboxyl group, an alkoxy group, an aryloxy group, an acyloxy group, a carbamoyloxy group, an acylamino group, an aminocarbonylamino group, an alkoxycarbonylamino group, an aryloxycarbonylamino group, a sulfamoylamino group, an alkyl- or arylsulfonylamino group, an alkylthio group, an arylthio group, a sulfamoyl group, an alkyl- or arylsulfonyl group, an aryloxycarbonyl group, an alkoxycarbonyl group, a carbamoyl group, an imido group, a silyl group or a ureido group.

When $R^1$ to $R^{13}$ do not contain any alcoholic hydroxyl group, each of $R^1$ to $R^{13}$ more preferably represents a hydrogen atom, a halogen atom, any of alkyl groups (including a cycloalkyl group, a bicycloalkyl group and a tricycloalkyl group), a cyano group, an alkoxy group, an acyloxy group, an acylamino group, an aminocarbonylamino group, an alkoxycarbonylamino group, an alkyl- or arylsulfonylamino group, an alkylthio group, a sulfamoyl group, an alkyl- or arylsulfonyl group, an alkoxycarbonyl group or a carbamoyl group.

When $R^1$ to $R^{13}$ do not contain any alcoholic hydroxyl group, especially preferably, each of $R^1$ to $R^{13}$ represents a hydrogen atom, any of alkyl groups (including a cycloalkyl group, a bicycloalkyl group and a tricycloalkyl group), a halogen atom or an alkoxy group.

In General Formula (IX), at least one of $R^1$ to $R^{13}$ contains an alcoholic hydroxyl group. Preferably, at least one of $R^9$ to $R^{13}$ contains an alcoholic hydroxyl group.

Z represents a single bond or a bivalent connecting group. The bivalent connecting group is, for example, an alkylene group, an arylene group, a carbonyl group, a sulfonyl group, a carbonyloxy group, a carbonylamino group, a sulfonylamido group, an ether group, a thioether group, an amino group, a disulfide group, an acyl group, an alkylsulfonyl group, -CH=CH-, -C≡C-, an aminocarbonylamino group, an aminosulfonylamino group or the like. The bivalent connecting group may have a substituent. The same substituents as mentioned above with respect to $R^1$ to $R^{13}$ can be employed. Preferably, Z is a single bond or a substituent exhibiting no electron withdrawing properties, such as an alkylene group, an arylene group, an ether group, a thioether group, an amino group, -CH=CH-, an aminocarbonylamino group or an aminosulfonylamino group. More preferably, Z is a single bond, an ether group or a thioether group. Most preferably, Z is a single bond.

As preferred particular examples of the above onium ions, there can be mentioned cation structures (A1) to (A36) listed in section [0095] of US 2007/0184384A. These however in no way limit the scope of usable onium ions.

The total amount of compounds (A1) of General Formula (I) added, based on the total solid content of the composition is preferably in the range of 0.1 to 40 mass%, more preferably 0.5 to 35 mass% and further preferably 3 to 30 mass%.

The molecular weight of any of the compounds (A1) of General Formula (I) is preferably in the range of 200 to 2000, especially preferably 400 to 1000.

The compounds (A1) of General Formula (I) can be synthesized by, for example, a method of sulfonating an aromatic compound having a cyclic aliphatic skeleton. For example, the acid generator (A1) of the present invention can be synthesized by the following scheme.

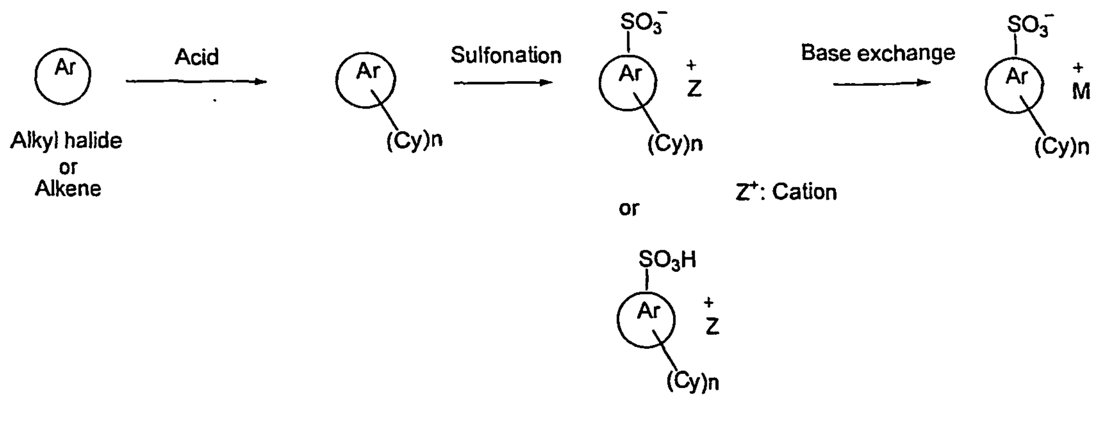


The sulfonation reaction can be carried out by use of any of reagents, such as chlorosulfonic acid (hydrolysis therewith), sulfuric acid, fuming sulfuric acid, $SO_3$, an $SO_3$ complex and a sulfite salt.

With respect to the counter cations, the conversion to desired cation $M^+$ can be effected by, for example, a conversion method using an ion exchange resin or a generally known anion exchange method as described in JP-A-6-184170, etc.

[2] Compound that when exposed to actinic rays or radiation, generates an acid (acid generator A2)

The composition of the present invention may contain, together with the acid generator (A1), another acid generator. Hereinafter, the acid generator other than the acid generator (A1) will be referred to as an "acid generator (A2)."

As the acid generator (A2), use can be made of a member appropriately selected from among a photoinitiator for photocationic polymerization, a photoinitiator for photoradical polymerization, a photo-achromatic agent and photo-discoloring agent for dyes, any of generally known compounds that when exposed to actinic rays or radiation, generate an acid, employed in microresists, etc., and mixtures thereof.

For example, as the acid generator, there can be mentioned a diazonium salt, a phosphonium salt, a sulfonium salt, an iodonium salt, an imide sulfonate, an oxime sulfonate, diazosulfone, disulfone or o-nitrobenzyl sulfonate.

Further, use can be made of compounds obtained by introducing any of the above groups or compounds that when exposed to actinic rays or radiation, generate an acid in a polymer principal chain or side chain, for example, compounds described in USP 3,849,137, DE 3914407, JP-A's-63-26653, 55-164824, 62-69263, 63-146038, 63-163452, 62-153853, 63-146029, etc.

Furthermore, use can be made of compounds that when exposed to light, generate an acid described in USP 3,779,778 and EP 126,712.

As preferred compounds among the acid generators, there can be mentioned those of the following general formulae (ZI), (ZII) and (ZIII).

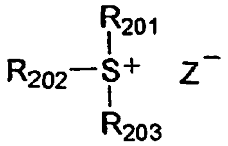
ZI

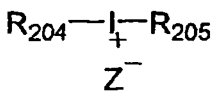
ZII

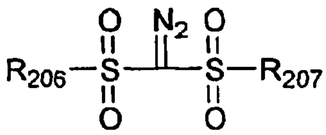
ZIII

In General Formulae (ZI) and (ZII), $R_{201}$, $R_{202}$ and $R_{203}$ have the same meanings as those of $R^4$ to $R^6$ appearing in above General Formula (VIII).

$R_{204}$ and $R_{205}$ have the same meanings as those of $R^2$ and $R^3$ appearing in above General Formula (VII).

Z- represents a non-nucleophilic anion.

As the nonnucleophilic anion represented by $Z^-$, there can be mentioned, for example, a sulfonate anion, a carboxylate anion, a sulfonylimido anion, a bis(alkylsulfonyl)imido anion, a tris(alkylsulfonyl)methyl anion or the like.

The nonnucleophilic anion means an anion whose capability of inducing a nucleophilic reaction is extremely low and is an anion capable of inhibiting any temporal decomposition by intramolecular nucleophilic reaction. This would realize an enhancement of the temporal stability of the resist.

As the sulfonate anion, there can be mentioned, for example, an aliphatic sulfonate anion, an aromatic sulfonate anion, a camphor sulfonate anion or the like.

As the carboxylate anion, there can be mentioned, for example, an aliphatic carboxylate anion, an aromatic carboxylate anion, an aralkyl carboxylate anion or the like.

The aliphatic moiety of the aliphatic sulfonate anion may be an alkyl group or a cycloalkyl group, being preferably an alkyl group having 1 to 30 carbon atoms or a cycloalkyl group having 3 to 30 carbon atoms. As such, there can be mentioned, for example, a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group, a boronyl group or the like.

As a preferred aromatic group of the aromatic sulfonate anion, there can be mentioned an aryl group having 6 to 14 carbon atoms, for example, a phenyl group, a tolyl group, a naphthyl group or the like.

The alkyl group, cycloalkyl group and aryl group of the aliphatic sulfonate anion and aromatic sulfonate anion may have a substituent. As the substituent of the alkyl group, cycloalkyl group and aryl group of the aliphatic sulfonate anion and aromatic sulfonate anion, there can be mentioned, for example, a nitro group, a halogen atom (fluorine atom, chlorine atom, bromine atom or iodine atom), a carboxyl group, a hydroxyl group, an amino group, a cyano group, an alkoxy group (preferably having 1 to 5 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms) or the like. The aryl group or ring structure of these groups may further have an alkyl group (preferably having 1 to 15 carbon atoms) as its substituent.

As the aliphatic moiety of the aliphatic carboxylate anion, there can be mentioned the same alkyl groups and cycloalkyl groups as mentioned with respect to the aliphatic sulfonate anion.

As the aromatic group of the aromatic carboxylate anion, there can be mentioned the same aryl groups as mentioned with respect to the aromatic sulfonate anion.

As a preferred aralkyl group of the aralkyl carboxylate anion, there can be mentioned an aralkyl group having 6 to 12 carbon atoms, for example, a benzyl group, a phenethyl group, a naphthylmethyl group, a naphthylethyl group, a naphthylbutyl group or the like.

The alkyl group, cycloalkyl group, aryl group and aralkyl group of the aliphatic carboxylate anion, aromatic carboxylate anion and aralkyl carboxylate anion may have a substituent. As the substituent of the alkyl group, cycloalkyl group, aryl group and aralkyl group of the aliphatic carboxylate anion, aromatic carboxylate anion and aralkyl carboxylate anion, there can be mentioned, for example, the same halogen atom, alkyl group, cycloalkyl group, alkoxy group, alkylthio group, etc. as mentioned with respect to the aromatic sulfonate anion.

As the sulfonylimido anion, there can be mentioned, for example, a saccharin anion.

The alkyl group of the bis(alkylsulfonyl)imido anion and tris(alkylsulfonyl)methyl anion is preferably an alkyl group having 1 to 5 carbon atoms. As such, there can be mentioned, for example, a methyl group, an ethyl group, a propyl group, an isopropyl group, an n-butyl group, an isobutyl group, a sec-butyl group, a pentyl group, a neopentyl group or the like. As a substituent of these alkyl groups, there can be mentioned a halogen atom, an alkyl group substituted with a halogen atom, an alkoxy group, an alkylthio group or the like. An alkyl group substituted with a fluorine atom is preferred.

As the other nonnucleophilic anions, there can be mentioned, for example, phosphorus fluoride, boron fluoride, antimony fluoride and the like.

The nonnucleophilic anion represented by Z- is preferably selected from among an aliphatic sulfonate anion substituted at its $\alpha$-position of sulfonic acid with a fluorine atom, an aromatic sulfonate anion substituted with a fluorine atom or a group having a fluorine atom, a bis(alkylsulfonyl)imido anion whose alkyl group is substituted with a fluorine atom and a tris(alkylsulfonyl)methide anion whose alkyl group is substituted with a fluorine atom. More preferably, the nonnucleophilic anion is a perfluorinated aliphatic sulfonate anion having 4 to 8 carbon atoms or a benzene sulfonate anion having a fluorine atom. Still more preferably, the nonnucleophilic anion is a nonafluorobutane sulfonate anion, a perfluorooctane sulfonate anion, a pentafluorobenzene sulfonate anion or a 3,5-bis(trifluoromethyl)benzene sulfonate anion.

In General Formula (ZIII),
each of $R_{206}$ and $R_{207}$ independently represents an aryl group, an alkyl group or a cycloalkyl group.

The aryl group represented by $R_{206}$ and $R_{207}$ is preferably a phenyl group or a naphthyl group, more preferably a phenyl group. The aryl group represented by $R_{206}$ to $R_{207}$ may be one having a heterocyclic structure containing an oxygen atom, a nitrogen atom, a sulfur atom or the like. As the aryl group having a heterocyclic structure, there can be mentioned, for example, a pyrrole residue (group formed by loss of one hydrogen atom from pyrrole), a furan residue (group formed by loss of one hydrogen atom from furan), a thiophene residue (group formed by loss of one hydrogen atom from thiophene), an indole residue (group formed by loss of one hydrogen atom from indole), a benzofuran residue (group formed by loss of one hydrogen atom from benzofuran), a benzothiophene residue (group formed by loss of one hydrogen atom from benzothiophene) or the like.

As preferred alkyl groups and cycloalkyl groups represented by $R_{206}$ and $R_{207}$, there can be mentioned a linear or branched alkyl group having 1 to 10 carbon atoms (for example, a methyl group, an ethyl group, a propyl group, a butyl group or a pentyl group) and a cycloalkyl group having 3 to 10 carbon atoms (a cyclopentyl group, a cyclohexyl group or a norbornyl group).

The aryl group, alkyl group and cycloalkyl group represented by $R_{206}$ and $R_{207}$ may have a substituent. As a possible substituent on the aryl group, alkyl group and cycloalkyl group represented by $R_{206}$ and $R_{207}$, there can be mentioned, for example, an alkyl group (for example, 1 to 15 carbon atoms), a cycloalkyl group (for example, 3 to 15 carbon atoms), an aryl group (for example, 6 to 15 carbon atoms), an alkoxy group (for example, 1 to 15 carbon atoms), a halogen atom, a hydroxyl group, a phenylthio group or the like.

Z- represents a nonnucleophilic anion. As such, there can be mentioned the same nonnucleophilic anions as mentioned with respect to the Z- of General Formula (ZI).

As the acid generators, there can be further mentioned the compounds of following General Formulae (ZIV), (ZV) and (ZVI).

$$Ar_3-SO_2-SO_2-Ar_4$$

ZIV

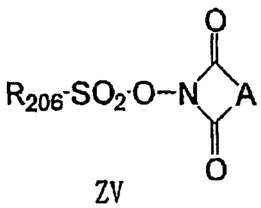

ZV

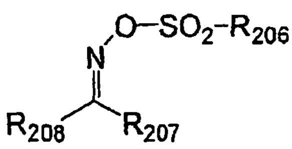

ZVI

In the general formulae (ZIV) to (ZVI), each of $Ar_3$ and $Ar_4$ independently represents an aryl group.

Each of $R_{206}$, $R_{207}$ and $R_{208}$ independently represents an alkyl group, a cycloalkyl group or an aryl group. A represents an alkylene group, an alkenylene group or an arylene group.

Among the acid generators, the compounds of General Formulae (ZI) to (ZIII) are more preferred.

As a preferred acid generator, there can be mentioned a compound that generates an acid having one sulfonate group or imido group. As a more preferred acid generator, there can be mentioned a compound that generates a monovalent perfluoroalkanesulfonic acid, a compound that generates a monovalent aromatic sulfonic acid substituted with a fluorine atom or fluorine-atom-containing group, or a compound that generates a monovalent imidic acid substituted with a fluorine atom or fluorine-atom-containing group. As a still more preferred acid generator, there can be mentioned any of sulfonium salts of fluorinated alkanesulfonic acid, fluorinated benzenesulfonic acid or fluorinated imidic acid. With respect to practicable acid generators, it is especially preferred for the generated acid to be a fluorinated alkanesulfonic acid, fluorinated benzenesulfonic acid or fluorinated imidic acid of -1 or below pKa. By the use thereof, an enhancement of sensitivity can be attained.

Especially preferred examples of the acid generators are as follows.

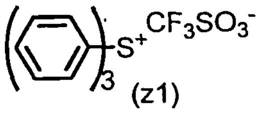
(z1)

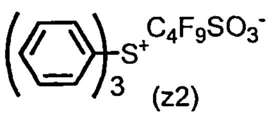
(z2)

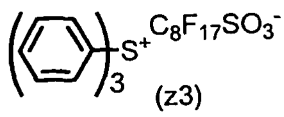
(z3)

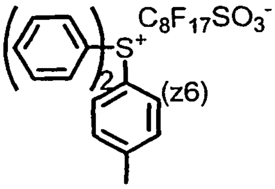
(z6)

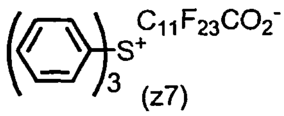
(z7)

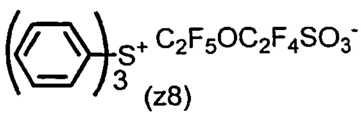
(z8)

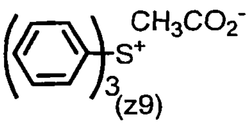
(z9)

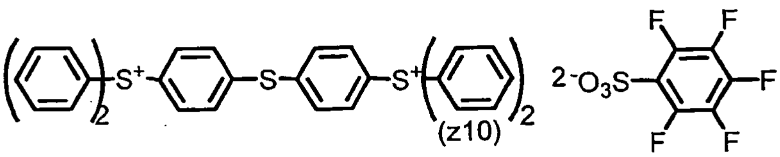
(z10)

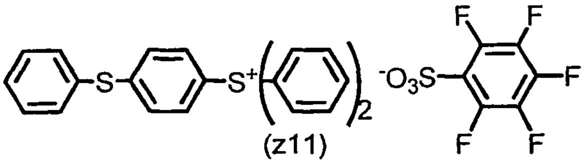
(z11)

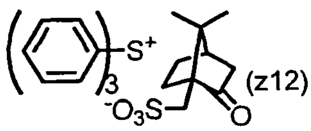
(z12)

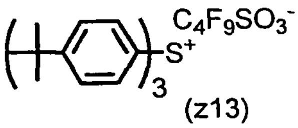
(z13)

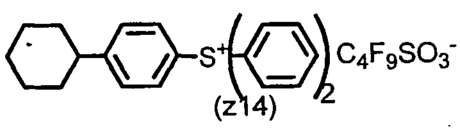
(z14)

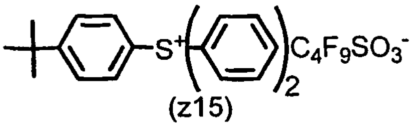
(z15)

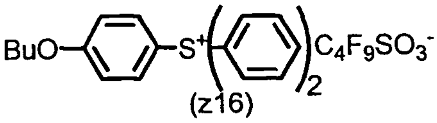
(z16)

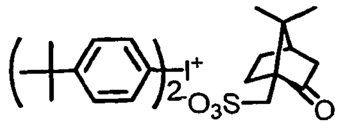
(z17)
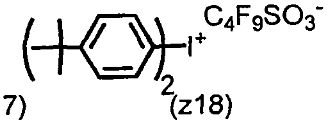
(z18)

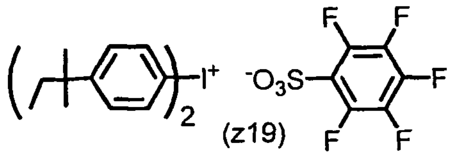
(z19)
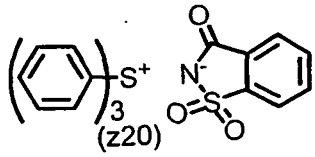
(z20)

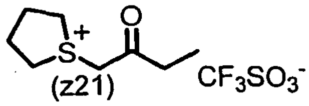
(z21)
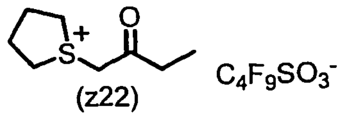
(z22)

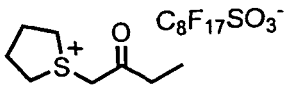
(z23)
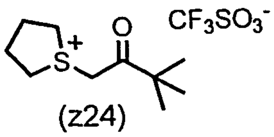
(z24)
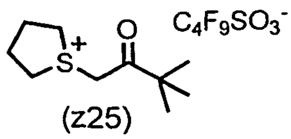
(z25)

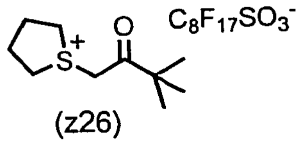
(z26)
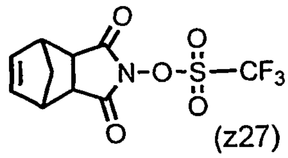
(z27)
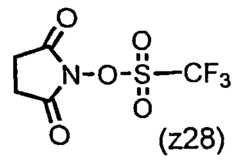
(z28)

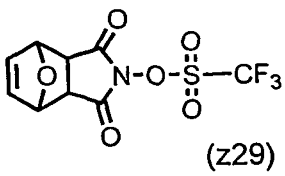
(z29)
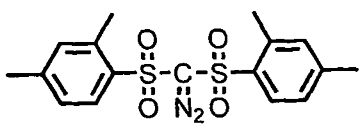
(z30)
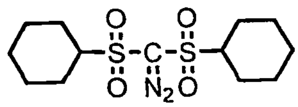
(z31)

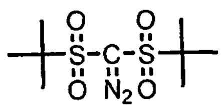
(z32)
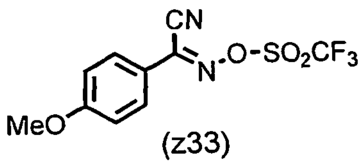
(z33)

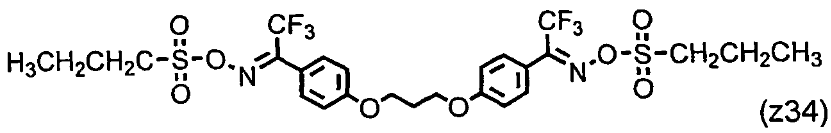
(z34)

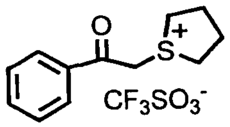
(z35)
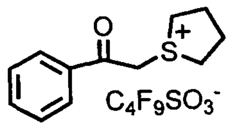
(z36)
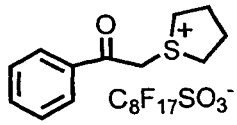
(z37)

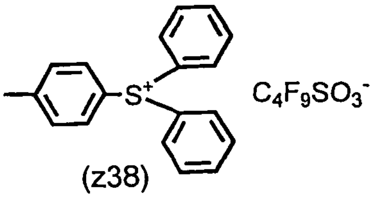
(z38)

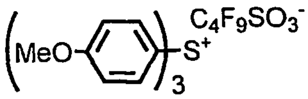
(z39)

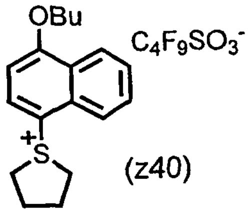
(z40)

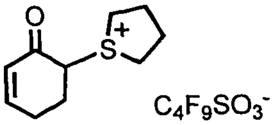
(z41)

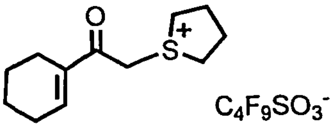
(z42)

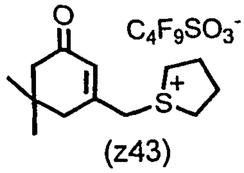
(z43)

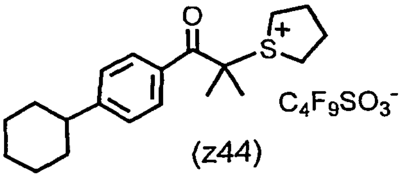
(z44)

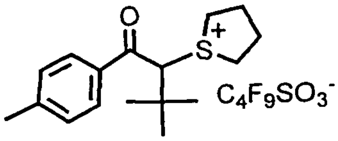
(z45)

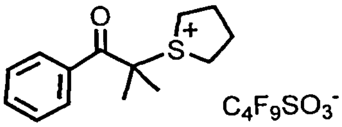
(z46)

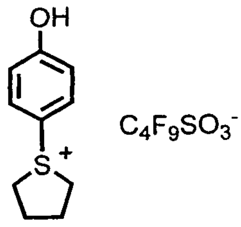
(z47)

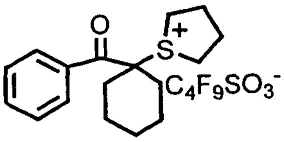
(z48)

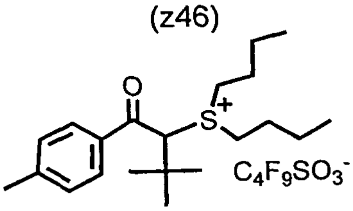
(z49)

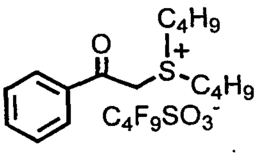
(z50)

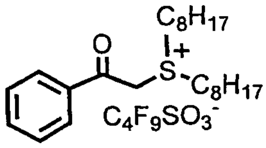
(z51)

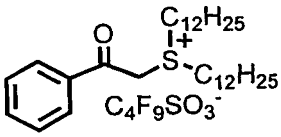
(z52)

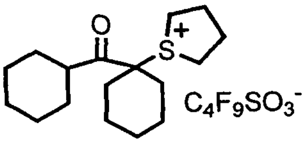
(z53)

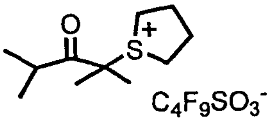
(z54)

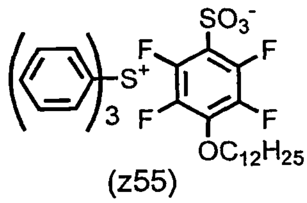
(z55)

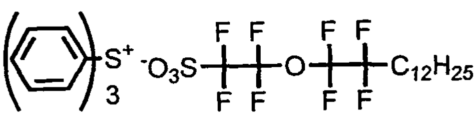
(z56)

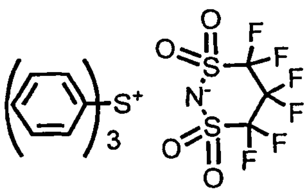
(z58)

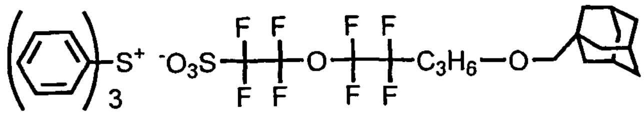

(z57)

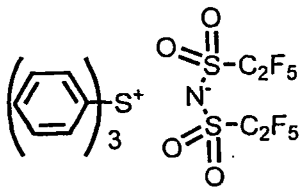

(z59)

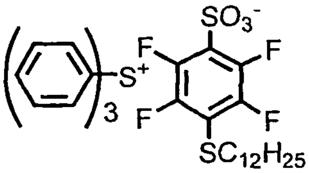

(z60)

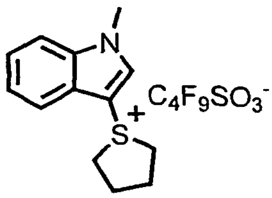

(z61)

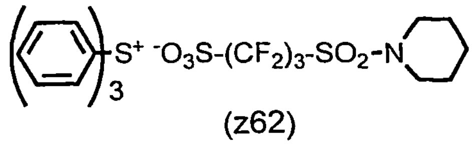

(z62)

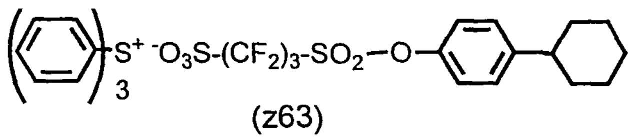

(z63)

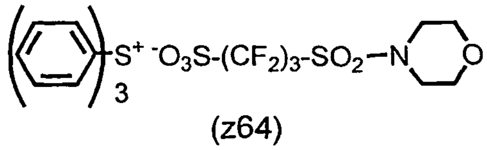

(z64)

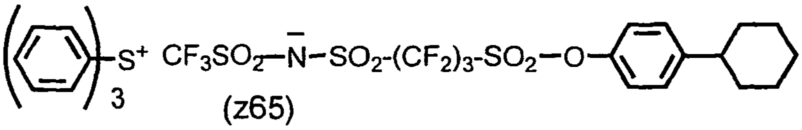

(z65)

The acid generators (A2) can also be used either individually or in combination.

The amount of acid generator (A2) added, based on the acid generator (A1), is generally 100 mass% or less, preferably 80 mass% or less and more preferably 60 mass% or less.

[3] Resin (B) that is decomposed by the action of an acid to thereby exhibit an increased solubility in an alkali developer

The resin that is decomposed by the action of an acid to thereby exhibit an increased solubility in an alkali developer (hereinafter also referred to as "acid-decomposable resin") for use in the composition of the present invention is a resin having, in its principal chain or side chain or both thereof, a group (acid-decomposable group) that is decomposed by the action of an acid to thereby generate an alkali-soluble group. Among them, a resin having an acid-decomposable group in its side chain is preferred.

The acid-decomposable group is preferably a group resulting from substitution of the hydrogen atom of an alkali-soluble group, such as a -COOH group or an -OH group, with an acid-eliminable group.

In the present invention, the acid-decomposable group is preferably an acetal group or a tertiary ester group.

The matrix resin to which the above groups decomposable by the action of an acid are bonded as side chains refers to an alkali-soluble resin having an -OH or -COOH group in its side chain. For example, there can be mentioned the alkali-soluble resins to be described hereinafter.

The alkali dissolution rate of the alkali-soluble resins upon the formation into a resist film as measured in a 0.261 N tetramethylammonium hydroxide (TMAH) (23°C) is preferably 8 nm/sec or greater. The alkali dissolution rate is especially preferably 16 nm/sec or greater.

The acid-decomposable resins preferably each contain a repeating unit having an aromatic group. An acid-decomposable resin having a hydroxystyrene repeating unit (hereinafter also referred to as "resin (B1)") is especially preferred. Copolymers of hydroxystyrene/hydroxystyrene protected by an acid-decomposable group and hydroxystyrene/(meth)acrylic acid tert-alkyl ester are more preferred.

The content of acid-decomposable groups is defined as the quotient of the formula B/(B+S) in which (B) is the number of groups decomposable by an acid in the resin and (S) is the number of alkali-soluble groups not protected by an acid-eliminable group in the resin. The content is preferably in the range of 0.01 to 0.7, more preferably 0.05 to 0.50 and further more preferably 0.05 to 0.40.

The resin (B) for use in the present invention is a resin that has the residue (c) of a compound having an ionization potential (Ip) value lower than that of phenol and when acted on by an acid, exhibits an increased solubility in an alkali developer.

The Ip value referred to herein is one obtained by a molecular orbital calculation according to MOPAC. The molecular orbital calculation according to MOPAC is carried out in accordance with the method disclosed in James J.P. Stewart, Journal of Computer-Aided Molecular Design, Vol. 4, No. 1 (1990), pp. 1-105.

This molecular orbital calculation can be carried out using, for example, the software CAChe available from Oxford Molecular, Inc.

Among the parameters used in the calculation, parameter PM3 is preferred.

The thus calculated Ip value of phenol is 9.175 eV. The Ip value of the compound having an Ip value lower than that of phenol from which the residue (c) is derived is preferably below 9.0, more preferably 8.8 or below and further more preferably 8.5 or below.

The lower limit of the Ip value is not particularly limited. However, the Ip value is preferably 2 or higher, more preferably 3 or higher and further more preferably 4 or higher.

In the present invention, the residue (c) of a compound having an Ip value lower than that of phenol refers to a group resulting from the removal of one hydrogen atom from the compound with the above Ip value. The compound having the ionization potential value lower than that of phenol is represented by X-O-H, the residue (c) is X-O-. According to the invention, X is a group represented by after-mentioned Formula (III):

-L-Y (III)

The resin (B) may contain a repeating unit (D) having a group in which the hydrogen atom of an acid group (a phenolic hydroxyl or carboxylic group) has been replaced by a group that is eliminable by the action of an acid. It is preferred for the resin (B) to contain the residue (c) in the repeating unit (D). More preferably, the residue (c) is contained in the group that is eliminable by the action of an acid within the repeating unit (D).

As the monomer from which the repeating unit (D) having a group protected by a group that is eliminable by the action of an acid is derived, there can be mentioned a compound having at least one unsaturated bond capable of addition polymerization, selected from among substituted styrenes such as p-hydroxystyrene, m-hydroxystyrene, vinylbenzoic acid and styrenesulfonic acid, (meth)acrylic esters, (meth)acrylamides, maleic anhydride, fumaric esters, maleimides, allyl compounds, vinyl ethers, vinyl esters and the like.

The monomer from which the repeating unit (D) having a group protected by a group that is eliminable by the action of an acid is derived can be synthesized by, for example, adding a vinyl ether with a given eliminable group to a side chain of the above monomer with an unsaturated bond capable of addition polymerization.

The resin (B) for use in the present invention contains any of the repeating units of General Formula (II) below as the repeating unit (D).

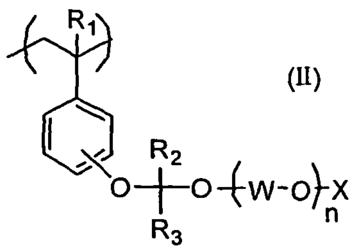

(II)

In the formula (II), $R_1$ represents a hydrogen atom or a methyl group.

Each of $R_2$ and $R_3$ independently represents a hydrogen atom, an alkyl group, a cycloalkyl group, an aryl group or an aralkyl group.

W represents a bivalent organic group.

X represents an organic group, and -O-X is the residue (c) of H-O-X having an ionization potential value lower

than that of phenol.

n is an integer of 1 to 4, preferably 1 or 2.

When n is an integer of 2 to 4, a plurality of W groups may be identical with or different from each other.

In the formula (II), the group that is eliminable by the action of an acid corresponds to the moiety ranging from the carbon atom to which both $R_2$ and $R_3$ are bonded to the portion of X.

The bivalent organic group represented by W is any one or a combination of two or more groups selected from the group consisting of an alkylene group, a cycloalkylene group, an ether group, a thioether group, a carbonyl group, an ester group, an amido group, a sulfonamido group, a urethane group and a urea group. As the alkylene group, there can be mentioned any of the groups of the following formula.

-[C(Rf) (Rg)]r-

In the formula, each of Rf and Rg represents a hydrogen atom, an alkyl group, a substituted alkyl group or an alkoxy group. They may be identical with or different from each other.

The alkyl group is preferably a lower alkyl group, such as a methyl group, an ethyl group, a propyl group, an isopropyl group or a butyl group. More preferably, the alkyl group is selected from among a methyl group, an ethyl group, a propyl group and an isopropyl group.

As the substituent of the substituted alkyl group, there can be mentioned an alkoxy group or the like.

As the alkoxy group, there can be mentioned an alkoxy group having 1 to 4 carbon atoms, such as a methoxy group, an ethoxy group, a propoxy group or a butoxy group.

In the formula, r is an integer of 1 to 10.

As the cycloalkylene group, there can be mentioned a cycloalkylene group having 3 to 10 carbon atoms, in particular, a cyclopentylene group, a cyclohexylene group, a cyclooctylene group or the like.

As a preferred example of the alkyl groups represented by $R_2$ and $R_3$, there can be mentioned, for example, an alkyl group having 1 to 8 carbon atoms, in particular, a methyl group, an ethyl group, a propyl group, an n-butyl group, a sec-butyl group, a hexyl group or an octyl group.

As a preferred example of the cycloalkyl groups represented by $R_2$ and $R_3$, there can be mentioned, for example, a cycloalkyl group having 3 to 15 carbon atoms, in particular, a cyclopentyl group, a cyclohexyl group, a norbornyl group or an adamantyl group.

As a preferred example of the aryl groups represented by $R_2$ and $R_3$, there can be mentioned, for example, an aryl group having 6 to 15 carbon atoms, in particular, a phenyl group, a tolyl group, a naphthyl group, an anthryl group or the like.

As a preferred example of the aralkyl groups represented by $R_2$ and $R_3$, there can be mentioned, for example, an aralkyl group having 6 to 20 carbon atoms, in particular, a benzyl group, a phenethyl group or the like.

The group X of the formula (II) has any of the structures of Formula (III) below.

-L-Y (III)

In the formula (III), L represents a single bond or an alkylene group. Y represents a group selected from among those of formula (IV) below.

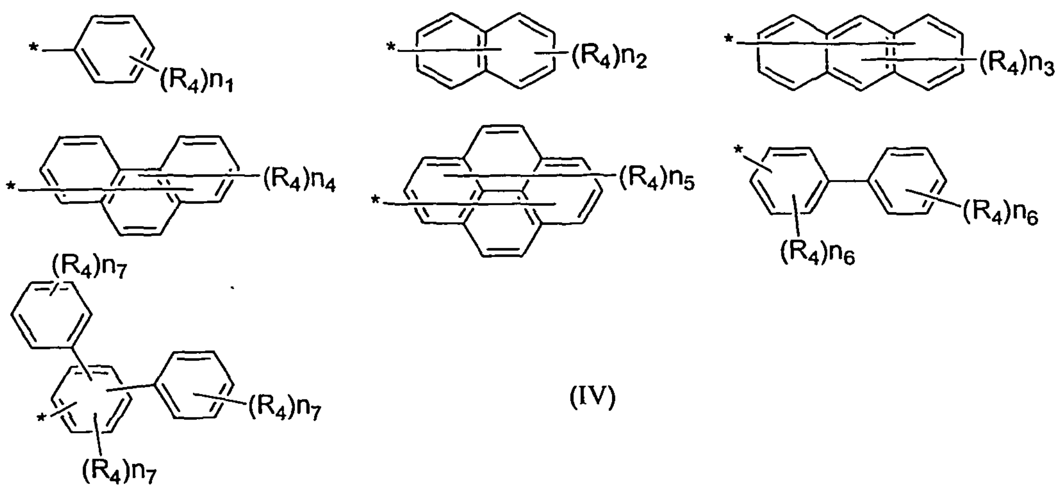

(IV)

In the formulae, each of $R_4$s independently represents a linear or branched alkyl group having 1 to 6 carbon atoms or an alkoxy group

In the formulae, $n_1$ is an integer of 0 to 3, $n_2$ is an integer of 0 to 7, $n_3$ is an integer of 0 to 9, $n_4$ is an integer of 0 to 9, $n_5$ is an integer of 0 to 9, $n_6$ is an integer of 0 to 3 and $n_7$ is an integer of 0 to 3.

In the formulae, * represents a site of connection with L.

General Formulae (III) and (IV) will be described in detail below.

As the alkylene groups represented by L, there can be mentioned the groups of the formula: -[C(Rf)(Rg)]r-.

In the formula, each of Rf and Rg represents a hydrogen atom, an alkyl group, a substituted alkyl group or an alkoxy group. They may be identical with or different from each other.

The alkyl group is preferably an alkyl group having 1 to 4 carbon atoms, such as a methyl group, an ethyl group, a propyl group, an isopropyl group or a butyl group. More preferably, the alkyl group is selected from among a methyl group, an ethyl group, a propyl group and an isopropyl group.

As the substituent of the substituted alkyl group, there can be mentioned an alkoxy group (preferably having 1 to 4 carbon atoms) or the like.

As the alkoxy group, there can be mentioned an alkoxy group having 1 to 4 carbon atoms, such as a methoxy group, an ethoxy group, a propoxy group or a butoxy group.

In the formula, r is an integer of 1 to 10.

The linear or branched alkyl group having 1 to 6 carbon atoms represented by R4 is a methyl group, an ethyl group, a propyl group, a butyl group, a pentyl group, a hexyl group or the like, and may have a substituent.

As the substituent, there can be mentioned a halogen atom, an alkoxy group, an alkoxycarbonyl group, an acyl group, an acyloxy group or the like. In the substituent, the number of carbon atoms is preferably 10 or less.

The alkoxy group represented by $R_4$ is, for example, an alkoxy group having 1 to 4 carbon atoms, such as a methoxy group, an ethoxy group, a propoxy group or a butoxy group. A methoxy group is preferred.

In the formulae, each of $n_1$ to $n_7$ is preferably an integer of 0 to 2, more preferably 0 or 1.

Among the groups of the formula (IV), the groups shown below are preferred from the viewpoint of the simultaneous resolution of development residue and outgassing performance.

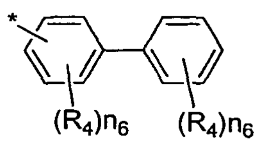
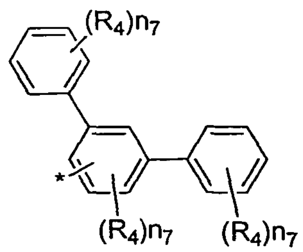

Particular examples of the repeating units containing a residue (c) as constituents of the resin (B) will be shown below, which however in no way limit the scope of the repeating units.

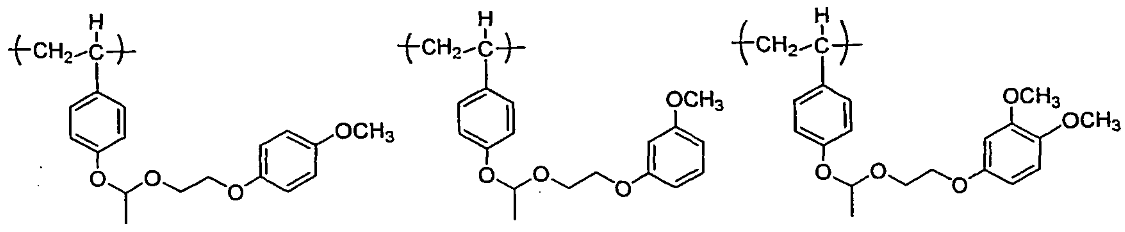

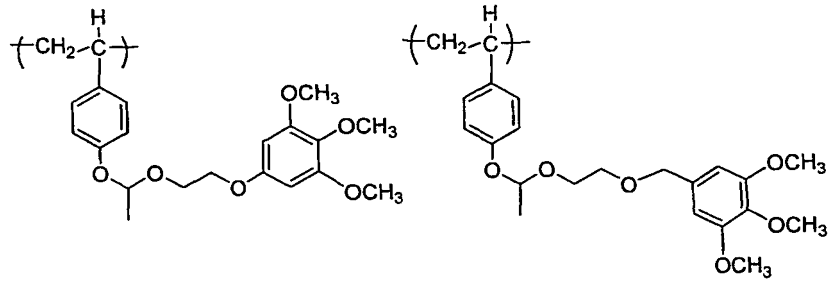

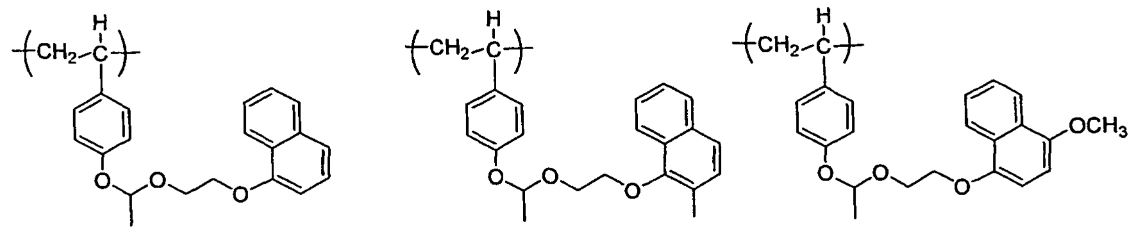

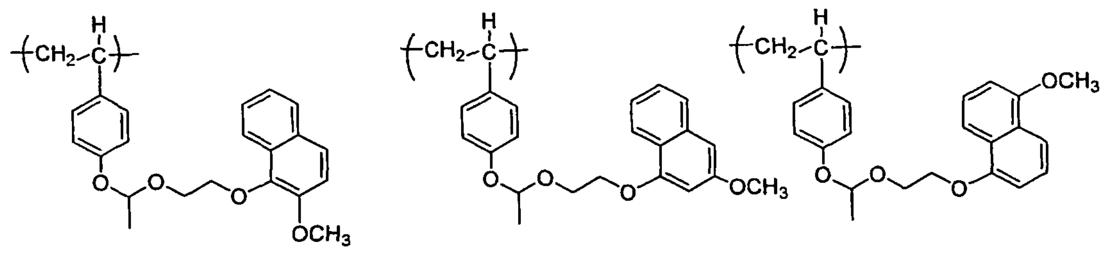

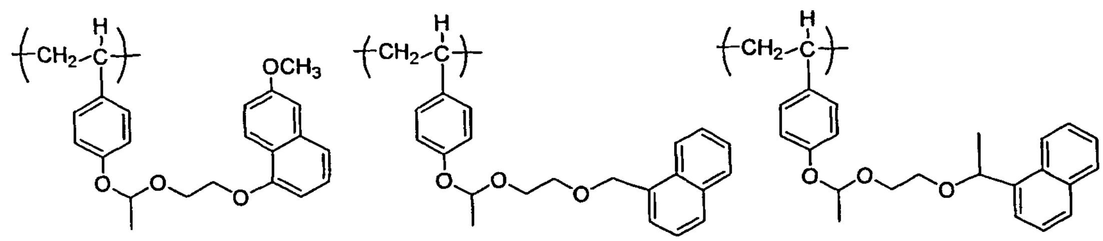

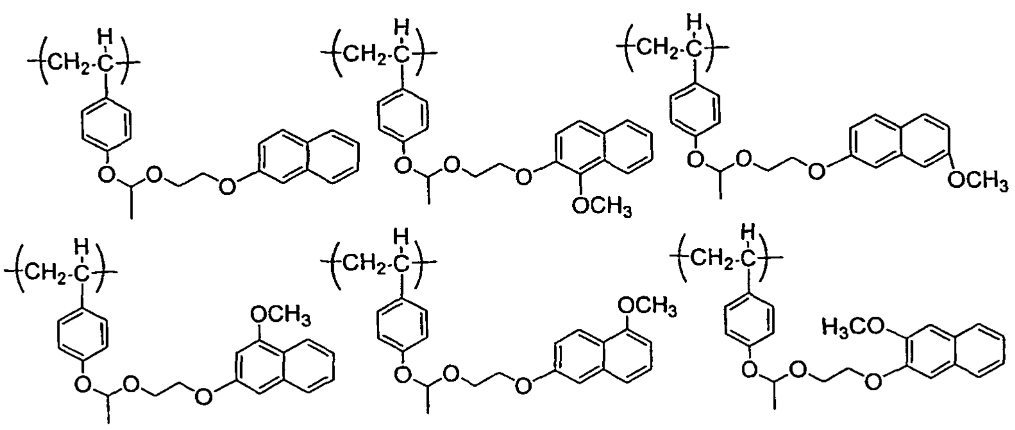

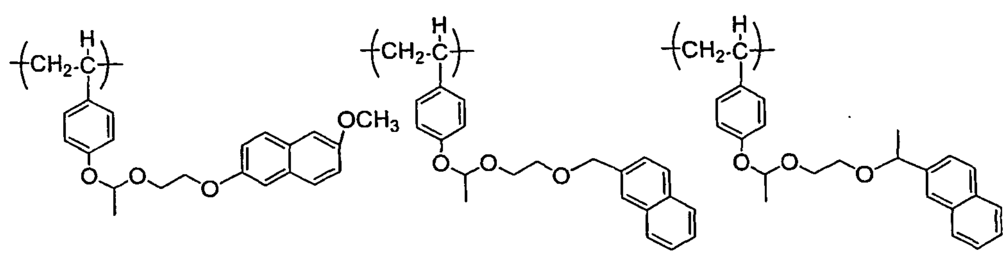

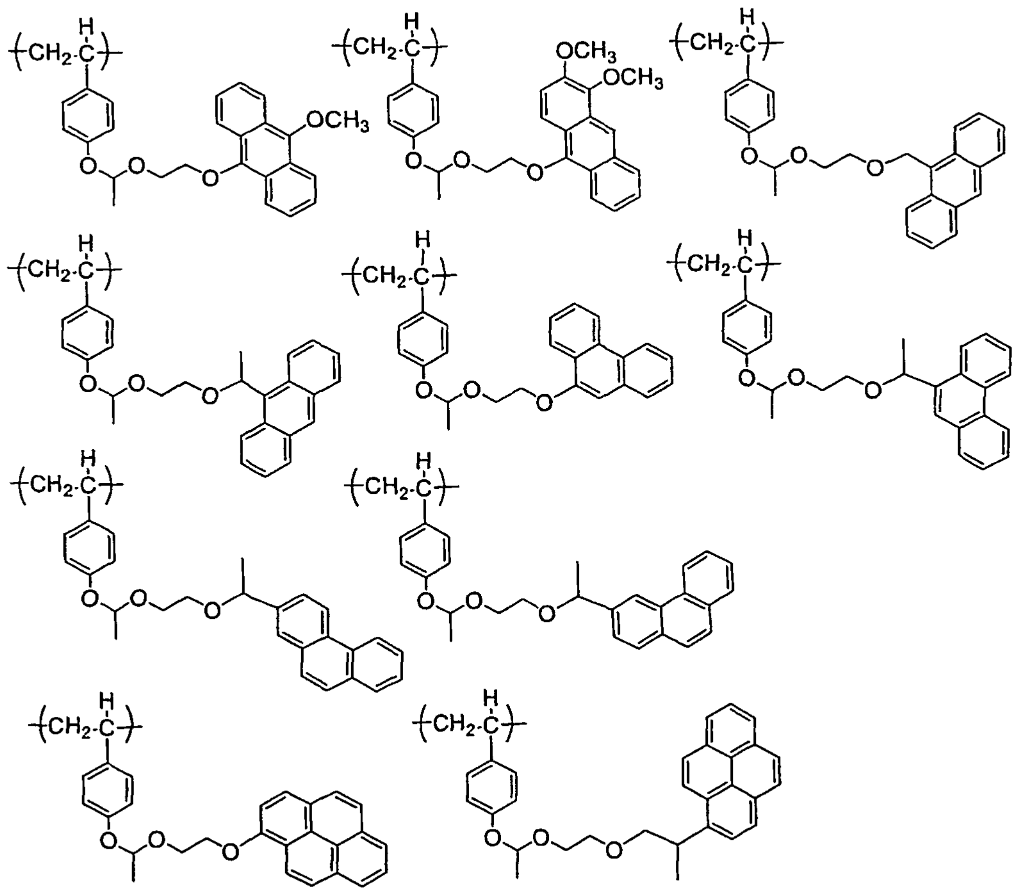

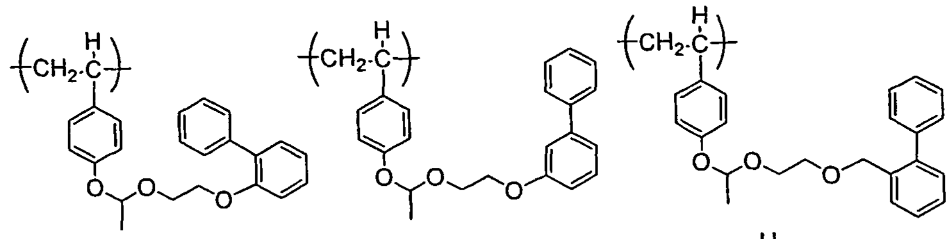

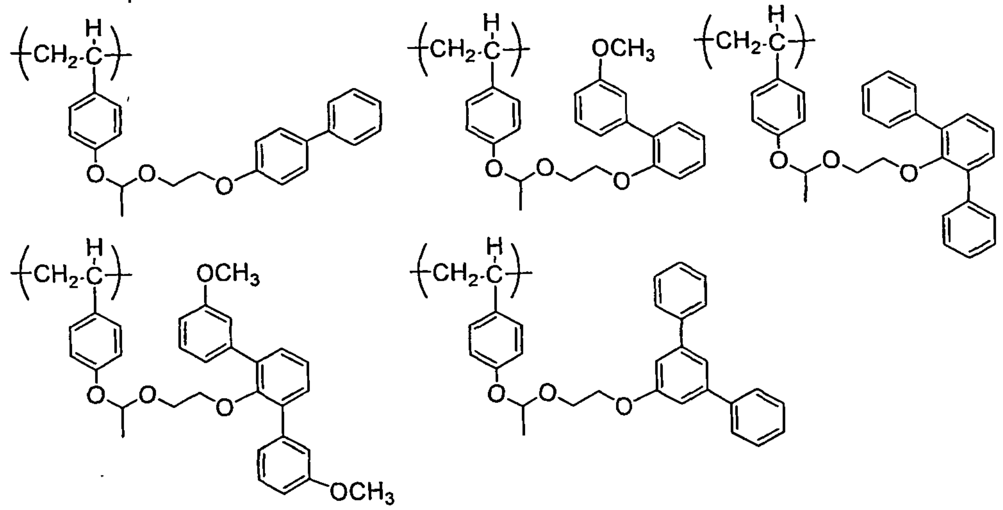

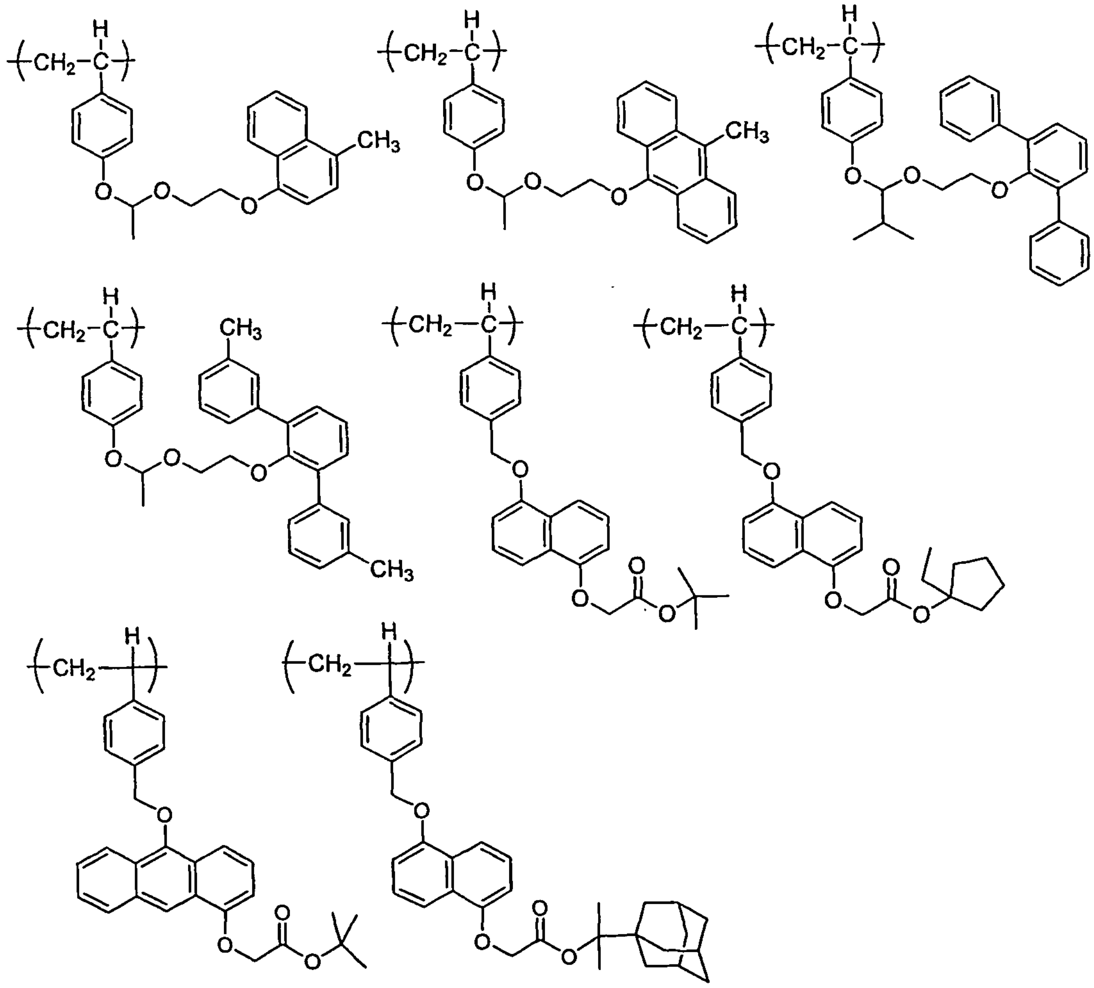

The resin (B) may have any of the repeating units of General Formula (V) below.

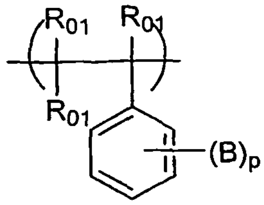

(V)

In General Formula (V), each of $R_{01}$s independently represents a hydrogen atom, an alkyl group, a cycloalkyl group, a halogen atom, a cyano group or an alkoxycarbonyl group.

B represents a halogen atom, a cyano group, an acyl group, an alkyl group, an alkoxy group, an acyloxy group or an alkoxycarbonyl group.

p is an integer of 0 to 5.

Each of $R_{01}$s appearing in General Formula (V) independently represents a hydrogen atom, an alkyl group, a cycloalkyl group, a halogen atom, a cyano group or an alkoxycarbonyl group. Preferably, the number of carbon atoms therein is 20 or less.

Each of the alkyl group and cycloalkyl group represented by $R_{01}$ preferably has 20 or less carbon atoms, which is, for example, a methyl group, an ethyl group, a propyl group, an isopropyl group, an n-butyl group, an isobutyl group, a t-butyl group, a pentyl group, a cyclopentyl group, a hexyl group, a cyclohexyl group, an octyl group, a dodecyl group or the like. These groups may have substituents. Examples of the substituents include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group, a heterocyclic residue such as a pyrrolidone residue and the like.

The number of carbon atoms is more preferably 10 or less. A $CF_3$ group, an alkoxycarbonylmethyl group, an alkylcarbonyloxymethyl group, a hydroxymethyl group, an alkoxymethyl group and the like are further more preferred.

As the halogen atom represented by $R_{01}$, there can be mentioned a fluorine atom, a chlorine atom, a bromine atom or an iodine atom. A fluorine atom is preferred.

The alkyl group contained in the alkoxycarbonylmethyl group represented by $R_{01}$ is preferably the same as that represented by $R_{01}$.

The acyl group represented by B in General Formula (V) is, for example, an acyl group having 2 to 8 carbon atoms. Preferred examples thereof include a formyl group, an acetyl group, a propanoyl group, a butanoyl group, a pivaloyl group, a benzoyl group and the like.

The alkyl group represented by B is, for example, an alkyl group having 1 to 8 carbon atoms. As preferred particular examples thereof, there can be mentioned a methyl group, an ethyl group, a propyl group, an n-butyl group, a sec-butyl group, a hexyl group and an octyl group.

The alkoxy group represented by B is, for example, an alkoxy group having 1 to 8 carbon atoms. As particular examples thereof, there can be mentioned a methoxy group, an ethoxy group, a propoxy group, a butoxy group, a pentyloxy group, a hexyloxy group, a cyclohexyloxy group and the like.

As the acyloxy group or alkoxycarbonyl group represented by B, there can be mentioned any of those corresponding to the above acyl groups or alkoxy groups.

Among the above groups represented by B, an acyloxy group and an alkoxycarbonyl group are preferred. An acyloxy group is more preferred.

When the acyloxy group is any of those of General Formula -O-CO-$R_A$ in which $R_A$ is an alkyl group, $R_A$ preferably has 1 to 6 carbon atoms, more preferably 1 to 3 carbon atoms. The acyloxy group in which $R_A$ has one carbon atom (namely, an acetoxy group) is especially preferred.

In the formula, p is an integer of 0 to 5, preferably 0 to 2, more preferably 1 to 2 and further more preferably 1.

These groups each may have a substituent. As preferred substituents, there can be mentioned a hydroxyl group, a carboxyl group, a cyano group, a halogen group (a fluorine atom, a chlorine atom, a bromine atom or an iodine atom), an alkoxy group (a methoxy group, an ethoxy group, a propoxy group, a butoxy group or the like) and the like. With respect to the ring structures, as substituents, there can further be mentioned an alkyl group (preferably having 1 to 8 carbon atoms).

Particular examples of the repeating units of General Formula (V) will be shown below, which however in no way limit the scope of the repeating units.

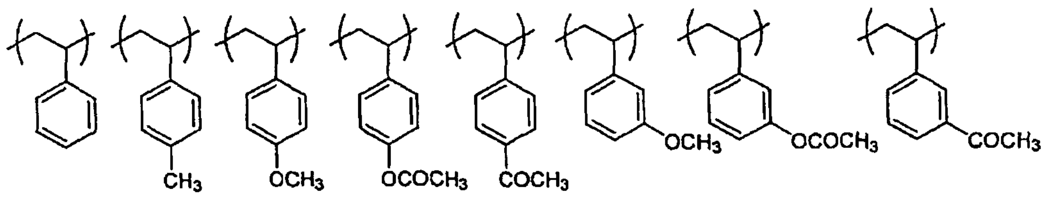

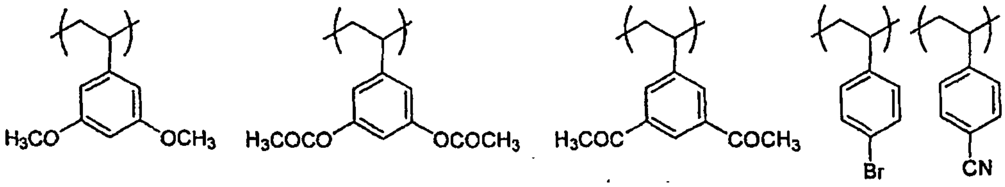

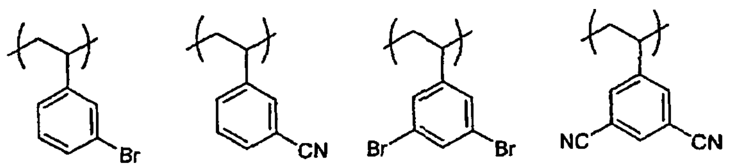

The resin (B) may have any of the repeating units of General Formula (VI) below.

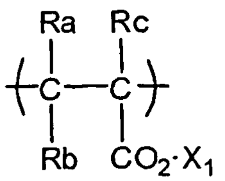

(VI)

In General Formula (VI), each of Ra to Rc independently represents a hydrogen atom, a fluorine atom, a chlorine atom, a cyano group or an alkyl group.

$X_1$ represents a hydrogen atom or an organic group.

In General Formula (VI), the alkyl groups represented by Ra to Rc each preferably have 1 to 5 carbon atoms. As such, there can be mentioned, for example, a methyl group, an ethyl group and a propyl group.

The organic group represented by $X_1$ preferably has 1 to 40 carbon atoms. It may be an acid-decomposable group or a non-acid-decomposable group.

As the non-acid-decomposable group represented by $X_1$, there can be mentioned, for example, an alkyl group, a cycloalkyl group, an alkenyl group, an aryl group or the like, provided that those whose portion bonded to the oxygen atom of an ester bond is a tertiary carbon are not included in the alkyl and cycloalkyl groups.

Among the non-acid-decomposable groups, the alkyl group is preferably an alkyl group having 1 to 4 carbon atoms, such as a methyl group, an ethyl group, a propyl group, an n-butyl group or a sec-butyl group. The cycloalkyl group is preferably a cycloalkyl group having 3 to 10 carbon atoms, such as a cyclopropyl group, a cyclobutyl group, a cyclohexyl group or an adamantyl group. The alkenyl group is preferably an alkenyl group having 2 to 4 carbon atoms, such as a vinyl group, a propenyl group, an allyl group or a butenyl group. The aryl group is preferably an aryl group having 6 to 14 carbon atoms, such as a phenyl group, a xylyl group, a toluyl group, a cumenyl group, a naphthyl group or an anthracenyl group.

As the acid-decomposable organic group represented by $X_1$, there can be mentioned, for example, $-C(R_{11a})(R_{12a})(R_{13a})$, $-C(R_{14a})(R_{15a})(OR_{16a})$ or $-CO-OC(R_{11a})(R_{12a})(R_{13a})$.

Each of $R_{11a}$ to $R_{13a}$ independently represents an alkyl group, a cycloalkyl group, an alkenyl group, an aralkyl group or an aryl group. Each of $R_{14a}$ and $R_{15a}$ independently represents a hydrogen atom or an alkyl group. $R_{16a}$ represents an alkyl group, a cycloalkyl group, an alkenyl group, an aralkyl group or an aryl group. Two of $R_{11a}$, $R_{12a}$ and $R_{13a}$, or two of $R_{14a}$, $R_{15a}$ and $R_{16a}$ may be bonded to each other to thereby form a ring.

A group having an acid-decomposable group can be introduced in the groups $X_1$ by modification. The groups $X_1$ having an acid-decomposable group thus introduced are, for example, as follows:

$$-[C(R_{17a})(R_{18a})]_p-CO-OC(R_{11a})(R_{12a})(R_{13a})$$

Each of $R_{17a}$ and $R_{18a}$ independently represents a hydrogen atom or an alkyl group, and p is an integer of 1 to 4.

It is preferred for the organic group represented by $X_1$ to be an acid-decomposable group with at least one cyclic structure selected from among alicyclic, arocyclic and bridged alicyclic structures. In particular, a structure having an aromatic group (especially a phenyl group) and a structure containing any of the alicyclic or bridged alicyclic moieties of General Formulae (pI) to (pVI) below are preferred.

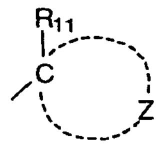
(pI)

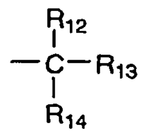
(pII)

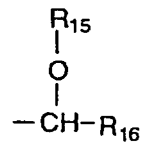
(pIII)

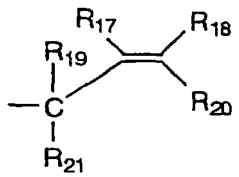
(pIV)

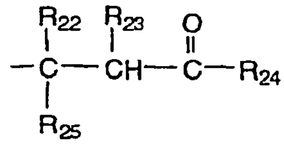
(pV)

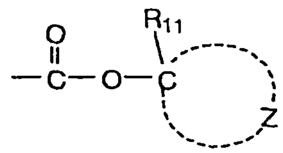
(pVI)

In the formulae, $R_{11}$ represents a methyl group, an ethyl group, an n-propyl group, an isopropyl group, an n-butyl group, an isobutyl group or a sec-butyl group. Z represents an atomic group required for forming an alicyclic hydrocarbon group in cooperation with a carbon atom.

Each of $R_{12}$ to $R_{16}$ independently represents a linear or branched alkyl group or alicyclic hydrocarbon group having 1 to 4 carbon atoms, provided that at least one of $R_{12}$ to $R_{14}$, or either $R_{15}$ or $R_{16}$ represents an alicyclic hydrocarbon group.

Each of $R_{17}$ to $R_{21}$ independently represents a hydrogen atom or a linear or branched alkyl group or alicyclic hydrocarbon group having 1 to 4 carbon atoms, provided that at least one of $R_{17}$ to $R_{21}$ represents an alicyclic hydrocarbon group. Either $R_{19}$ or $R_{21}$ represents a linear or branched alkyl group or alicyclic hydrocarbon group having 1 to 4 carbon atoms.

Each of $R_{22}$ to $R_{25}$ independently represents a hydrogen atom or a linear or branched alkyl group or alicyclic hydrocarbon group having 1 to 4 carbon atoms, provided that at least one of $R_{22}$ to $R_{25}$ represents an alicyclic hydrocarbon group. $R_{23}$ and $R_{24}$ may be bonded to each other to thereby form a ring.

In General Formulae (pI) to (pVI), each of the alkyl groups represented by $R_{12}$ to $R_{25}$ is a linear or branched alkyl group having 1 to 4 carbon atoms, which may be substituted or unsubstituted. As the alkyl group, there can be mentioned, for example, a methyl group, an ethyl group, an n-propyl group, an isopropyl group, an n-butyl group, an isobutyl group, a sec-butyl group, a t-butyl group or the like.

When the alkyl group is substituted, as the substituent, there can be mentioned an alkoxy group having 1 to 4 carbon atoms, a halogen atom (a fluorine atom, a chlorine atom, a bromine atom or an iodine atom), an acyl group, an acyloxy group, a cyano group, a hydroxyl group, a carboxyl group, an alkoxycarbonyl group, a nitro group or the like.

The alicyclic hydrocarbon groups represented by $R_{11}$ to $R_{25}$ and the alicyclic hydrocarbon groups formed by Z and a carbon atom may be monocyclic or polycyclic. In particular, there can be mentioned groups of a monocyclo, bicyclo, tricyclo or tetracyclo structure or the like having 5 or more carbon atoms. The number of carbon atoms thereof is preferably in the range of 6 to 30, especially preferably 7 to 25. These alicyclic hydrocarbon groups may have substituents.

As alicyclic structures preferred in the present invention, there can be mentioned an adamantyl structure, a noradamantyl structure, a decalin structure, a tricyclodecanyl structure, a tetracyclododecanyl structure, a norbornyl structure, a cedrol structure, a cyclopentyl structure, a cyclohexyl structure, a cycloheptyl structure, a cyclooctyl structure, a cyclodecanyl structure and a cyclododecanyl structure. As more preferred structures, there can be mentioned an adamantyl structure, a decalin structure, a norbornyl structure, a cedrol structure, a cyclohexyl structure, a cycloheptyl structure, a cyclooctyl structure, a cyclodecanyl structure and a cyclodecanyl structure.

As substituents that may be introduced in the alicyclic hydrocarbon groups, there can be mentioned, for example, an alkyl group, a halogen atom, a hydroxyl group, an alkoxy group, a carboxyl group and an alkoxycarbonyl group. The alkyl group is preferably a lower alkyl group, such as a methyl group, an ethyl group, a propyl group, an isopropyl group or a butyl group. More preferably, the alkyl group substituent is selected from the group consisting of a methyl group,

an ethyl group, a propyl group and an isopropyl group. As the above alkoxy group, there can be mentioned an alkoxy group having 1 to 4 carbon atoms, such as a methoxy group, an ethoxy group, a propoxy group or a butoxy group.

These alkyl groups, alkoxy groups and alkoxycarbonyl groups may further have substituents.

As such substituents, there can be mentioned, for example, an alkoxy group having 1 to 4 carbon atoms (a methoxy group, an ethoxy group, a butoxy group or the like), a hydroxyl group, an oxo group, an alkylcarbonyl group (preferably 2 to 5 carbon atoms), an alkylcarbonyloxy group (preferably 2 to 5 carbon atoms), an alkoxycarbonyl group (preferably 2 to 5 carbon atoms), a halogen atom (a chlorine atom, a bromine atom, a fluorine atom or the like) and the like.

Moreover, as preferred acid-decomposable groups represented by $X_1$, there can also be mentioned the atomic groups of the formula -CH(Rn)-AR in which Rn represents an alkyl group or an aryl group and AR represents an aryl group as described in, for example, JP-A-2008-096951.

With respect to the resin (B), for maintaining a desirable developability with an alkali developer, the above monomers may be copolymerized with other appropriate polymerizable monomers so that an alkali-soluble group, such as a phenolic hydroxyl group, a carboxyl group, a sulfonate group or a hexafluoroisopropanol group ($-C(CF_3)_2OH$), can be introduced. Also, for improving the film quality, the above monomers may be copolymerized with other hydrophobic polymerizable monomers, such as an alkyl acrylate and an alkyl methacrylate.

In the present invention, the content of repeating units having an acid-decomposable group containing the residue (c) based on the sum of repeating units constituting the resin (B) is preferably in the range of 5 to 60 mol%, more preferably 5 to 40 mol% and most preferably 10 to 30 mol%.

The content of repeating units of General Formula (V) based on the sum of repeating units constituting the resin is preferably in the range of 0 to 50 mol%, more preferably 10 to 40 mol% and most preferably 15 to 30 mol%.

The content of repeating units of General Formula (VI) based on the sum of repeating units constituting the resin is preferably in the range of 0 to 30 mol%, more preferably 0 to 20 mol% and most preferably 0 to 10 mol%.

The content of repeating units having a non-hydroxyl alkali-soluble group, such as a carboxyl group or a sulfonate group, based on the sum of repeating units constituting the resin is preferably in the range of 0 to 10 mol%, more preferably 1 to 8 mol% and most preferably 2 to 6 mol%.

The resin (B) can be synthesized using any of the radical polymerization, anionic polymerization and cationic polymerization methods. The radical polymerization method is preferred from the viewpoint of control of copolymerization reaction. A living radical polymerization method is especially preferred from the viewpoint of control of molecular weight and molecular weight distribution. In particular, there can be mentioned a method in which a compound selected from among nitroxide compounds, atomic transfer polymerization method systems and RAFT agents is used in combination with a radical polymerization initiator (an azo system or a peroxide system). An acid-decomposable protective group can be introduced by a method of copolymerizing a monomer having an acid-decomposable protective group or a method in which a protective group is introduced in a resin having an alkali-soluble hydroxyl, such as phenolic hydroxyl, or a carboxyl group. Moreover, the resin can be synthesized by generally known synthetic methods, such as a method of copolymerizing a monomer having an acid-decomposable group with various monomers or a method of reacting a precursor of acid-decomposable group with alkali-soluble resins, as described in EP 254853 and JP-A's 2-258500, 3-223860 and 4-251259.

The thus synthesized resin is usually purified to remove impurities, such as unreacted monomers, likely to adversely affect the desired performance by methods, such as reprecipitation and washing, commonly performed in the polymer synthesis before the use in a resist composition.

The weight average molecular weight, in terms of polystyrene molecular weight by GPC, of the resin (B) is preferably 30,000 or less, more preferably 1000 to 30,000, further more preferably 3000 to 20,000 and most preferably 3000 to 15,000.

The dispersity (Mw/Mn) of the resin (B) is preferably in the range of 1.0 to 3.0, more preferably 1.05 to 2.0 and further more preferably 1.1 to 1.7.

A plurality of resins (B) may be used in combination.

Specific examples of the resins (B) will be shown below, which however in no way limit the scope of the resins (B).

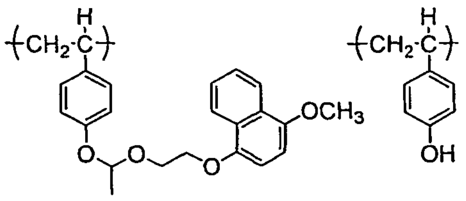

(R-1)

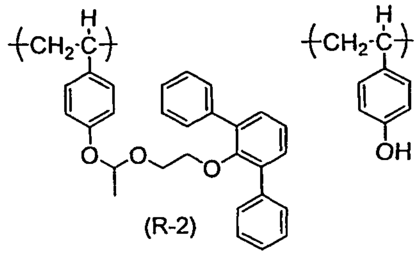

(R-2)

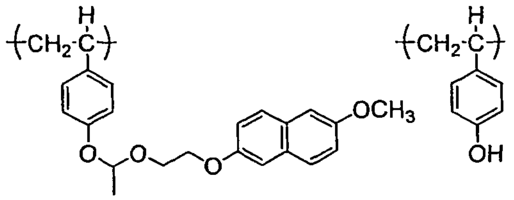

(R-3)

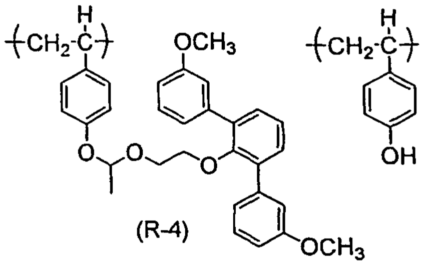

(R-4)

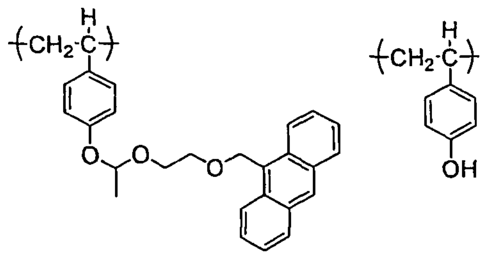

(R-5)

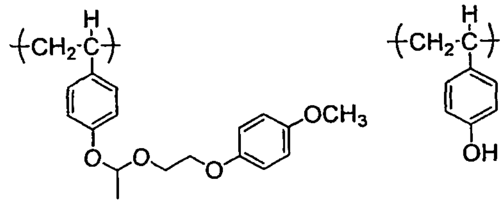

(R-6)

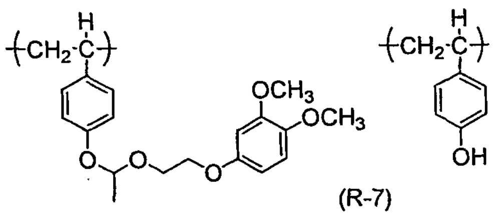

(R-7)

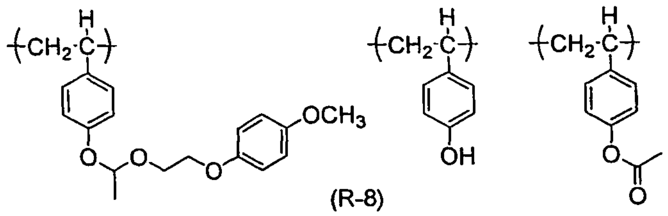

(R-8)

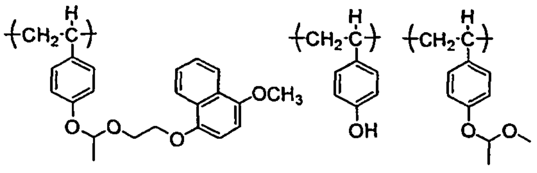

(R-9)

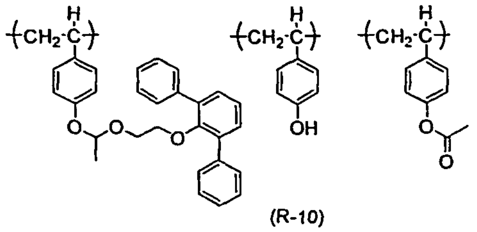

(R-10)

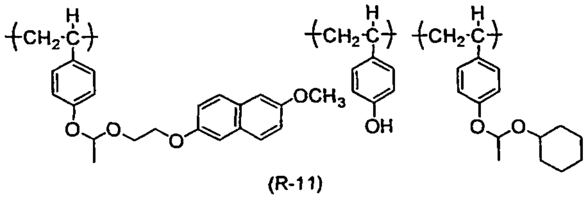

(R-11)

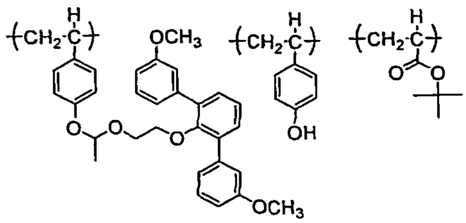

(R-12)

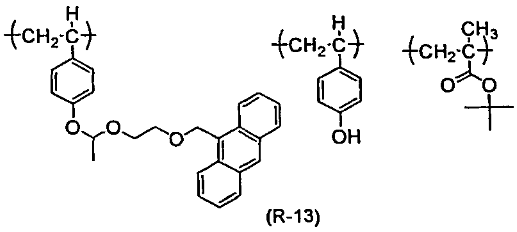

(R-13)

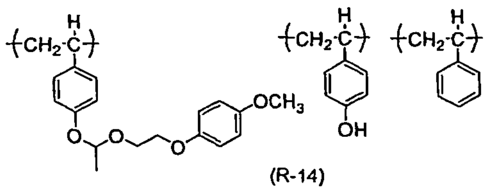

(R-14)

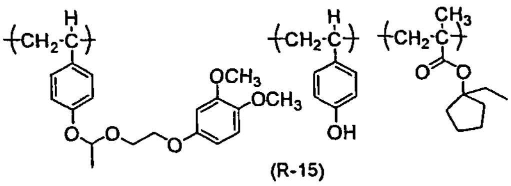

(R-15)

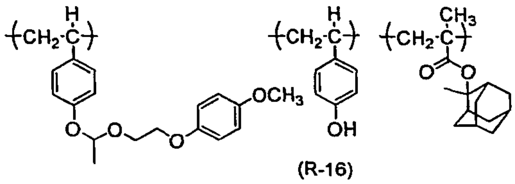

(R-16)

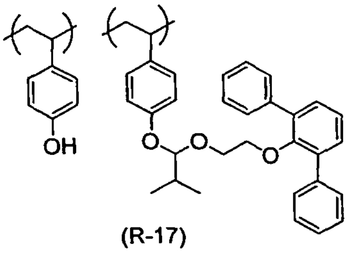

(R-17)

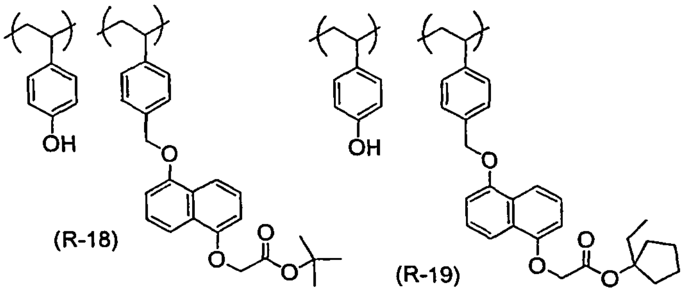

(R-18) (R-19)

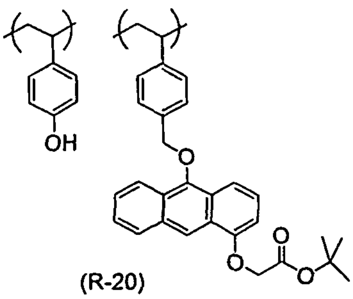

(R-20)

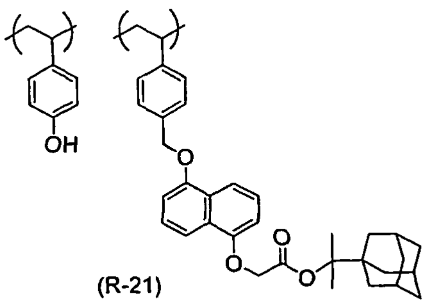

(R-21)

In the actinic-ray- or radiation-sensitive resin composition of the present invention, the content of resin (B) based on the total solid of the composition is preferably in the range of 45 to 99 mass%, more preferably 55 to 97 mass% and further more preferably 60 to 90 mass%.

[4] Resin (C) soluble in alkali developer

Hereinafter, this resin may also be referred to as "component (C)" or "alkali-soluble resin."

The alkali dissolution rate of the alkali-soluble resin as measured in a 0.261 N tetramethylammonium hydroxide (TMAH) (23°C) is preferably 2 nm/sec or higher, especially preferably 20 nm/sec or higher.

As the alkali-soluble resin for use in the present invention, there can be mentioned, for example, a novolak resin, a hydrogenated novolak resin, an acetone-pyrogallol resin, an o-polyhydroxystyrene, a m-polyhydroxystyrene, a p-polyhydroxystyrene, a hydrogenated polyhydroxystyrene, a halogenated or alkylated polyhydroxystyrene, a hydroxystyrene-N-substituted maleimide copolymer, an o/p- and m/p-hydroxystyrene copolymer, a partial O-alkylation product of hydroxyl of polyhydroxystyrene (for example, a 5 to 30 mol% O-methylation product, O-(1-methoxy)ethylation product, O-(1-ethoxy)ethylation product, O-2-tetrahydropyranylation product, O-(t-butoxycarbonyl)methylation product, etc.), an O-acylation product thereof (for example, a 5 to 30 mol% O-acetylation product, O-(t-butoxy)carbonylation product, etc.), a styrene-maleic anhydride copolymer, a styrene-hydroxystyrene copolymer, an α-methylstyrene-hydroxystyrene copolymer, a carboxylated methacrylic resin or its derivative, or a polyvinyl alcohol derivative. However, the alkali-soluble resins are not limited to these.

Especially preferred alkali-soluble resins are a novolak resin, an o-polyhydroxystyrene, a m-polyhydroxystyrene, a p-polyhydroxystyrene, a copolymer of these polyhydroxystyrenes, an alkylated polyhydroxystyrene, a partial O-alkylation product or O-acylation product of polyhydroxystyrene, a styrene-hydroxystyrene copolymer and an α-methylstyrene-hydroxystyrene copolymer.

The above novolak resin can be obtained by addition condensation of a given monomer as a main component with an aldehyde conducted in the presence of an acid catalyst.

The weight average molecular weight of the alkali-soluble resin is 2000 or greater, preferably from 5000 to 200,000 and more preferably 5000 to 100,000.

Herein, the weight average molecular weight is in terms of polystyrene molecular weight measured by gel permeation chromatography.

In the present invention, two or more types of alkali-soluble resins (C) may be used in combination.

The amount of alkali-soluble resin added, based on the solid contents of the whole photosensitive composition, is in the range of 40 to 97 mass%, preferably 60 to 90 mass%.

[5] Dissolution inhibiting compound of 3000 or less molecular weight (D) that is decomposed by the action of an acid to thereby increase the solubility in an alkali developer

Hereinafter, this compound is also referred to as "component (D)" or " Dissolution inhibiting compound."

From the viewpoint of preventing any lowering of 220 nm or shorter transmission, the dissolution inhibiting compound of 3000 or less molecular weight (D) that is decomposed by the action of an acid to thereby increase the solubility in an alkali developer is preferably an alicyclic or aliphatic compound containing an acid-decomposable group, such as any of cholic acid derivatives having an acid-decomposable group described in Proceeding of SPIE, 2724, 355 (1996). The acid-decomposable group and alicyclic structure are the same as described above with respect to the alicyclic hydrocarbon based acid-decomposable resin.

When the composition of the present invention is exposed to a KrF excimer laser or irradiated with electron beams, preferred use is made of a compound containing a structure resulting from substitution of the phenolic hydroxyl group of a phenol compound with an acid-decomposable group. The phenol compound preferably contains 1 to 9 phenol skeletons, more preferably 2 to 6 phenol skeletons.

In the present invention, the molecular weight of each of the dissolution inhibiting compounds is 3000 or less, preferably 300 to 3000 and more preferably 500 to 2500.

The amount of dissolution inhibiting compound added is preferably in the range of 3 to 50 mass%, more preferably 5 to 40 mass% based on the solid contents of the photosensitive composition.

Specific examples of the dissolution inhibiting compounds will be shown below, which however in no way limit the scope of the present invention.

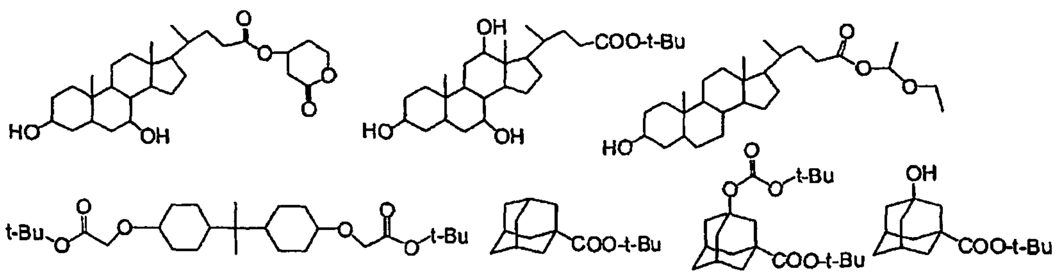

[6] Basic compound (E)

The actinic-ray- or radiation-sensitive resin composition of the present invention preferably contains a basic compound. The basic compound is preferably a nitrogenous organic basic compound. Useful basic compounds are not particularly limited. However, for example, the compounds of categories (1) to (4) below are preferably used.

(1) Compounds of General Formula (BS-1) below

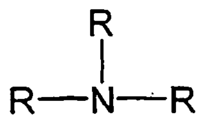

(BS-1)

In General Formula (BS-1), each of Rs independently represents any of a hydrogen atom, an alkyl group (linear or branched), a cycloalkyl group (monocyclic or polycyclic), an aryl group and an aralkyl group, provided that in no event all the three Rs are hydrogen atoms.

The number of carbon atoms of the alkyl group represented by R is not particularly limited. However, it is generally in the range of 1 to 20, preferably 1 to 12.

The number of carbon atoms of the cycloalkyl group represented by R is not particularly limited. However, it is generally in the range of 3 to 20, preferably 5 to 15.

The number of carbon atoms of the aryl group represented by R is not particularly limited. However, it is generally in the range of 6 to 20, preferably 6 to 10. In particular, a phenyl group, a naphthyl group and the like can be mentioned.

The number of carbon atoms of the aralkyl group represented by R is not particularly limited. However, it is generally in the range of 7 to 20, preferably 7 to 11. In particular, a benzyl group and the like can be mentioned.

In the alkyl group, cycloalkyl group, aryl group and aralkyl group represented by R, a hydrogen atom thereof may be replaced by a substituent. As the substituent, there can be mentioned, for example, an alkyl group, a cycloalkyl group, an aryl group, an aralkyl group, a hydroxyl group, a carboxyl group, an alkoxy group, an aryloxy group, an alkylcarbonyloxy group, an alkyloxycarbonyl group or the like.

In the compounds of General Formula (BS-1), it is preferred that only one of the three Rs be a hydrogen atom, and also that none of the Rs be a hydrogen atom.

Specific examples of the compounds of General Formula (BS-1) include tri-n-butylamine, tri-n-pentylamine, tri-n-octylamine, tri-n-decylamine, triisodecylamine, dicyclohexylmethylamine, tetradecylamine, pentadecylamine, hexadecylamine, octadecylamine, didecylamine, methyloctadecylamine, dimethylundecylamine, N,N-dimethyldodecylamine, methyldioctadecylamine, N,N-dibutylaniline, N,N-dihexylaniline, 2,6-diisopropylaniline, 2,4,6-tri(t-butyl)aniline and the like.

Any of the compounds of General Formula (BS-1) in which at least one of the Rs is a hydroxylated alkyl group can be mentioned as a preferred form of compound. Specific examples of the compounds include triethanolamine, N, N-dihydroxyethylaniline and the like.

With respect to the alkyl group represented by R, an oxygen atom may be present in the alkyl chain to thereby form an oxyalkylene chain. The oxyalkylene chain preferably consists of $-CH_2CH_2O-$. As particular examples thereof, there can be mentioned tris(methoxyethoxyethyl)amine, compounds shown in column 3 line 60 et seq. of USP 6,040,112 and the like.

(2) Compounds with nitrogenous heterocyclic structure

The heterocyclic structure optionally may have aromaticity. It may have a plurality of nitrogen atoms, and also may have a heteroatom other than nitrogen. For example, there can be mentioned compounds with an imidazole structure (2-phenylbenzoimidazole, 2,4,5-triphenylimidazole and the like), compounds with a piperidine structure (N-hydroxyethylpiperidine, bis(1,2,2,6,6-pentamethyl-4-piperidyl) sebacate and the like), compounds with a pyridine structure (4-dimethylaminopyridine and the like) and compounds with an antipyrine structure (antipyrine, hydroxyantipyrine and the like).

Further, compounds with two or more ring structures can be appropriately used. For example, there can be mentioned 1,5-diazabicyclo[4.3.0]non-5-ene, 1,8-diazabicyclo[5.4.0]-undec-7-ene and the like.

(3) Amine compounds with phenoxy group The amine compounds with a phenoxy group are those having a phenoxy group at the end of the alkyl group of each amine compound opposite to the nitrogen atom. The phenoxy group may have a substituent, such as an alkyl group, an alkoxy group, a halogen atom, a cyano group, a nitro group, a

carboxyl group, a carboxylic ester group, a sulfonic ester group, an aryl group, an aralkyl group, an acyloxy group, an aryloxy group or the like.

Compounds having at least one oxyalkylene chain between the phenoxy group and the nitrogen atom are preferred. The number of oxyalkylene chains in each molecule is preferably in the range of 3 to 9, more preferably 4 to 6. Among the oxyalkylene chains, $-CH_2CH_2O-$ is preferred.
Particular examples thereof include 2-[2-{2-(2,2-dimethoxy-phenoxyethoxy)ethyl}-bis-(2-methoxyethyl)]-amine, compounds (C1-1) to (C3-3) shown in section [0066] of US 2007/0224539 A1 and the like.

(4) Ammonium salts

Ammonium salts can also be appropriately used. Hydroxides and carboxylates are preferred. Preferred particular examples thereof are tetraalkylammonium hydroxides, such as tetrabutylammonium hydroxide.
Also, use can be made of compounds synthesized in Examples of JP-A-2002-363146, compounds described in section [0108] of JP-A-2007-298569, and the like. These basic compounds are used alone or in combination.
The amount of basic compound added is generally in the range of 0.001 to 10 mass%, preferably 0.01 to 5 mass%, based on the total solid of the composition.
The molar ratio of acid generator to basic compound is preferably in the range of 1.0 to 300. A molar ratio of 2.5 or higher is preferred from the viewpoint of sensitivity and resolving power. A molar ratio of 300 or below is preferred from the viewpoint of suppressing any resolving power drop due to pattern thickening over time until baking treatment after exposure. The molar ratio is more preferably in the range of 5.0 to 200, further more preferably 7.0 to 150.

[7] Surfactant (F)

Preferably, the composition of the present invention further contains a surfactant. The surfactant is preferably a fluorinated and/or siliconized surfactant.
As such a surfactant, there can be mentioned Megafac F176 or Megafac R08 produced by Dainippon Ink & Chemicals, Inc., PF656 or PF6320 produced by OMNOVA SOLUTIONS, INC., Troy Sol S-366 produced by Troy Chemical Co., Ltd., Florad FC430 produced by Sumitomo 3M Ltd., polysiloxane polymer KP-341 produced by Shin-Etsu Chemical Co., Ltd., or the like.
Surfactants other than these fluorinated and/or siliconized surfactants can also be used. In particular, the other surfactants include polyoxyethylene alkyl ethers, polyoxyethylene alkyl aryl ethers and the like.
Moreover, generally known surfactants can also be appropriately used. As useful surfactants, there can be mentioned, for example, those described in section [0273] et seq of US 2008/0248425 A1.
These surfactants may be used alone or in combination.
The amount of surfactant added is preferably in the range of 0.0001 to 2 mass%, more preferably 0.001 to 1 mass%, based on the total solid of the composition.

[8] Organic solvent (G)

The solvent for use in the preparation of the composition is not particularly limited as long as it can dissolve the components of the composition. As the solvent, there can be mentioned, for example, an alkylene glycol monoalkyl ether carboxylate (propylene glycol monomethyl ether acetate or the like), an alkylene glycol monoalkyl ether (propylene glycol monomethyl ether or the like), an alkyl lactate (ethyl lactate, methyl lactate or the like), a cyclolactone (γ-butyrolactone or the like, preferably having 4 to 10 carbon atoms), a linear or cyclic ketone (2-heptanone, cyclohexanone or the like, preferably having 4 to 10 carbon atoms), an alkylene carbonate (ethylene carbonate, propylene carbonate or the like), an alkyl carboxylate (preferably an alkyl acetate such as butyl acetate), an alkyl alkoxyacetate (ethyl ethoxypropionate), or the like. As other useful solvents, there can be mentioned, for example, those described in section [0244] et seq. of US 2008/0248425 A1 and the like.
Among the above solvents, an alkylene glycol monoalkyl ether carboxylate and an alkylene glycol monoalkyl ether are preferred.
These solvents may be used alone or in combination. When a plurality of solvents are mixed together, it is preferred to mix a hydroxylated solvent with a non-hydroxylated solvent. The mass ratio of hydroxylated solvent to non-hydroxylated solvent is in the range of 1/99 to 99/1, preferably 10/90 to 90/10 and more preferably 20/80 to 60/40.
The hydroxylated solvent is preferably an alkylene glycol monoalkyl ether. The non-hydroxylated solvent is preferably an alkylene glycol monoalkyl ether carboxylate.
In the present invention, a photosensitive composition whose solid content is generally in the range of 0.5 to 25 mass%, preferably 1.0 to 22 mass% and more preferably 1.5 to 15 mass% is prepared using a solvent alone, preferably

a plurality of solvents.

[9] Other additive (H)

The photosensitive composition of the present invention may further according to necessity contain a dye, a plasticizer, a surfactant other than the above-mentioned component (F), a photosensitizer, a compound capable of accelerating the dissolution in a developer, etc.

The compound capable of accelerating the dissolution in a developer that can be employed in the present invention is a low-molecular compound of 1000 or less molecular weight having two or more phenolic OH groups or one or more carboxyl groups. When a carboxyl group is contained, an alicyclic or aliphatic compound is preferred.

The amount of dissolution accelerating compound added, based on the mass of the resin as component (B) or resin as component (C), is preferably in the range of 2 to 50 mass%, more preferably 5 to 30 mass%. It is preferred for the amount to be up to 50 mass% from the viewpoint of suppression of any development residue and prevention of any pattern distortion at development.

The above phenolic compound of 1000 or less molecular weight can be easily synthesized by persons of ordinary skill in the art to which the present invention pertains while consulting the processes described in, for example, JP-A's 4-122938 and 2-28531, USP 4,916,210 and EP 219294.

As the carboxylated alicyclic or aliphatic compound, there can be mentioned, for example, a carboxylic acid derivative of steroid structure such as cholic acid, deoxycholic acid or lithocholic acid, an adamantanecarboxylic acid derivative, adamantanedicarboxylic acid, cyclohexanecarboxylic acid, cyclohexanedicarboxylic acid or the like. These are however nonlimiting.

[11] Method of forming pattern

The composition of the present invention is used in such a manner that the above components are dissolved in a given organic solvent, preferably the above mixed solvent, and applied onto a given support in the following manner.

For example, the photosensitive composition is applied onto a substrate, such as one for use in the production of precision integrated circuit elements (e.g., silicon/silicon dioxide coating), by appropriate application means, such as a spinner or coater, and dried to thereby form a photosensitive film. In advance, the substrate may be provided with an antireflection film known in the art.

The photosensitive film is exposed through a given mask to actinic rays or radiation, preferably baked (heated), and developed. Accordingly, a desirable pattern can be obtained.

In the stage of irradiation with actinic rays or radiation, exposure (liquid immersion exposure) may be carried out after filling the interstice between the photosensitive film and a lens with a liquid of refractive index higher than that of air. This would realize an enhancement of resolving power.

As the actinic rays or radiation, there can be mentioned infrared rays, visible light, ultraviolet rays, extreme ultraviolet rays, far ultraviolet rays, X-rays, electron beams or the like. Among them, preferred use is made of far ultraviolet rays of especially 250 nm or less, more especially 220 nm or less wavelength, such as a KrF excimer laser (248 nm), an ArF excimer laser (193 nm) and an $F_2$ excimer laser (157 nm), as well as X-rays, electron beams and the like. More preferred use is made of an ArF excimer laser, an $F_2$ excimer laser, EUV (13 nm) and electron beams.

In the alkali developer for use in the development step, generally, use is made of a quaternary ammonium salt, such as tetramethylammonium hydroxide. However, other aqueous alkali solutions of an inorganic alkali, a primary to tertiary amine, an alcoholamine, a cycloamine, etc. can also be used.

Appropriate amounts of an alcohol and a surfactant can be added to the alkali developer before the use thereof.

The alkali concentration of the alkali developer is generally in the range of 0.1 to 20 mass%.

The pH value of the alkali developer is generally in the range of 10.0 to 15.0.

EXAMPLE

The present invention will be described in greater detail below with reference to Examples, which however in no way limit the scope of the present invention.

<Synthesis of acid generator A1>

(1) Synthesis of compound A1-1

<Synthesis of tricyclohexylbenzene>

Aluminum chloride amounting to 6.83 g was added to 20.0 g of benzene and agitated while cooling at 3°C. Then, 40.4 g of cyclohexyl chloride was slowly dropped thereinto. After the completion of the dropping, the mixture was agitated at room temperature for 5 hours and poured into ice water. An organic layer was extracted by use of ethyl acetate, and the obtained organic layer was distilled at 40°C under reduced pressure and further at 170°C under reduced pressure. The resultant matter was cooled to room temperature, and 50 ml of acetone was poured thereinto to thereby carry out recrystallization. The crystal obtained by the recrystallization was collected by filtration. Thus, 14 g of tricyclohexylbenzene was obtained.

<Synthesis of sodium tricyclohexylbenzenesulfonate>

Tricyclohexylbenzene amounting to 30 g was dissolved in 50 ml of methylene chloride, and agitated while cooling at 3°C. Then, 15.2 g of chlorosulfonic acid was slowly dropped thereinto. After the completion of the dropping, the mixture was agitated at room temperature for 5 hours, and 10 g of ice was poured thereinto. Further, 40 g of a 50% aqueous solution of sodium hydroxide was poured into the mixture, and 20 g of ethanol was added thereto. The mixture was agitated at 50°C for 1 hour, and any undissolved matter was removed by filtration. Vacuum distillation was carried out at 40°C, and separated crystals were collected by filtration. The crystals were washed with hexane. Thus, 30 g of sodium 1,3,5-tricyclohexylbenzenesulfonate was obtained.

<Synthesis of compound A1-1>

Triphenylsulfonium bromide A amounting to 4.0 g was dissolved in 20 ml of methanol, and 5.0 g of sodium 1,3,5-tricyclohexylbenzenesulfonate dissolved in 20 ml of methanol was added thereto. The mixture was agitated at room temperature for 2 hours, and 50 ml of ion exchanged water was added thereto. Extraction with chloroform was carried out, and the thus obtained organic layer was washed with water. Vacuum distillation thereof was carried out at 40°C, and the thus obtained crystals were recrystallized from a methanol/ethyl acetate solvent. Thus, 5.0 g of compound A1-1 was obtained.

$^1$H-NMR (400 MHz, $CDCl_3$): $\delta$ = 7.85 (d, 6H), 7.68 (t, 3H), 7.59 (t, 6H), 6.97 (s, 2H), 4.36-4.27 (m, 2H), 2.48-2.38 (m, 1H), 1.97-1.16 (m, 30H).

Compounds A1-2 to A1-10 were synthesized in the same manner as mentioned above.

The structures of the compounds A1-1 to A1-10 are shown below.

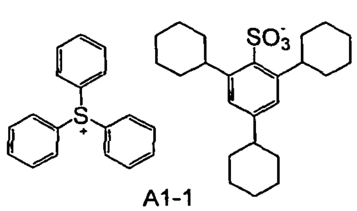

A1-1

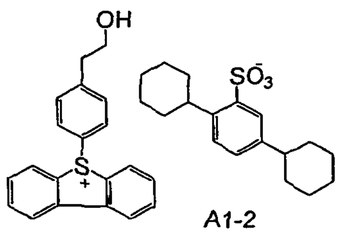

A1-2

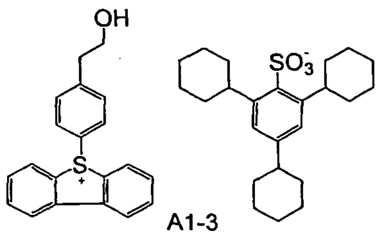

A1-3

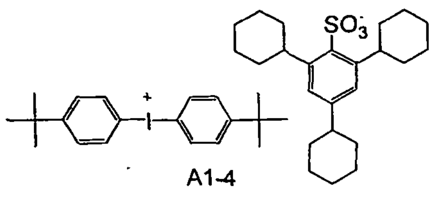

A1-4

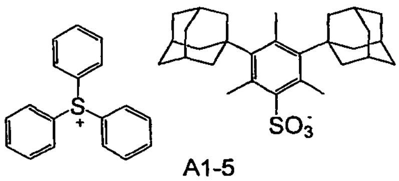

A1-5

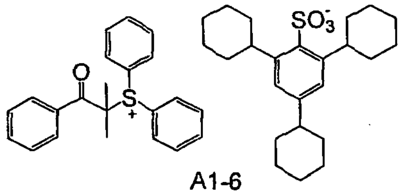

A1-6

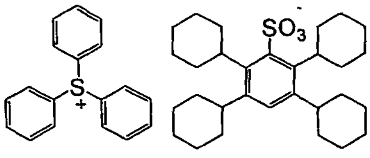

A1-7

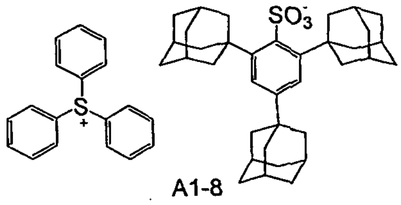

A1-8

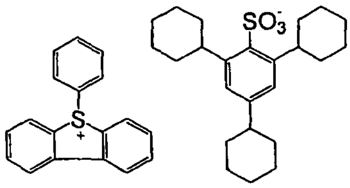

A1-9

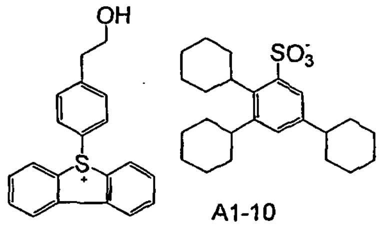

A1-10

The acid generator used in Comparative Examples is compound Z shown below.

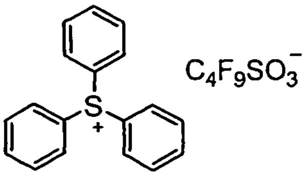

Z

<Resin (B) >

Resins (B-1) to (B-13) shown below were used as the resin (B). Resin (b-1) for Comparative Examples is also shown below. The numeral appearing on the right side of each repeating unit shown refers to the molar ratio of repeating units. Mw means the weight average molecular weight, and Mw/Mn refers to the dispersity of molecular weight.

(B-1)

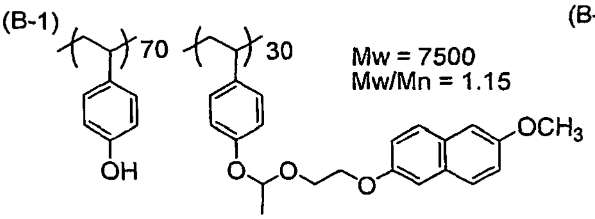

Mw = 7500
Mw/Mn = 1.15

(B-2)

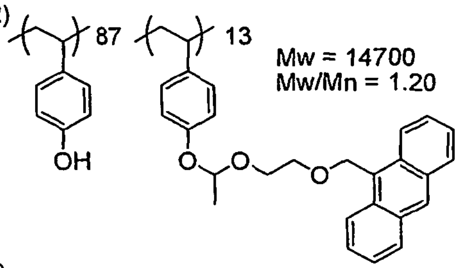

Mw = 14700
Mw/Mn = 1.20

(B-3)

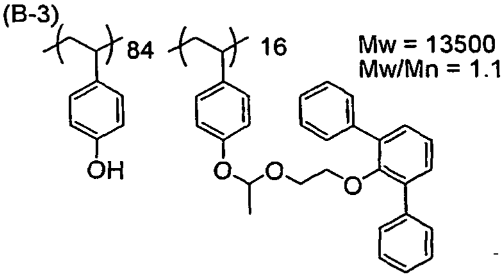

Mw = 13500
Mw/Mn = 1.18

(B-4)

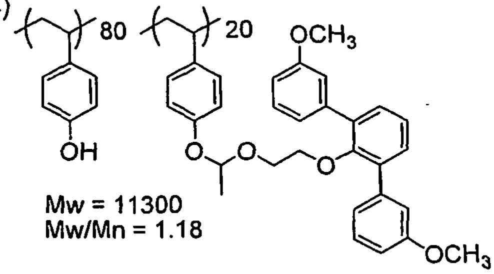

Mw = 11300
Mw/Mn = 1.18

(B-5)

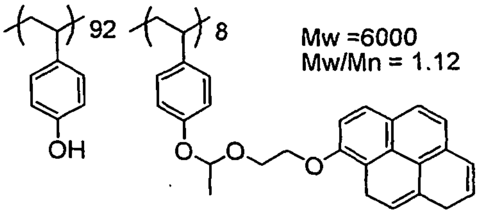

Mw =6000
Mw/Mn = 1.12

(B-6)

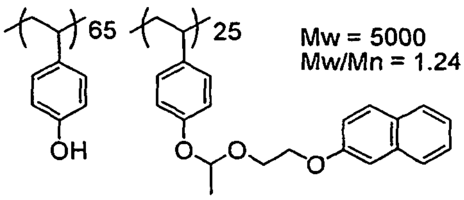

Mw = 5000
Mw/Mn = 1.24

(B-7)

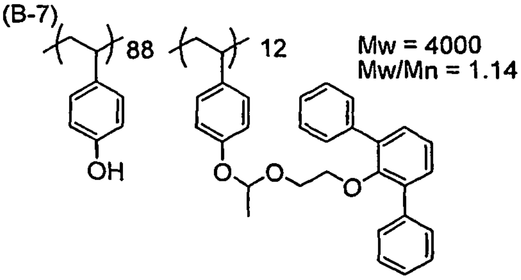

Mw = 4000
Mw/Mn = 1.14

(B-8)

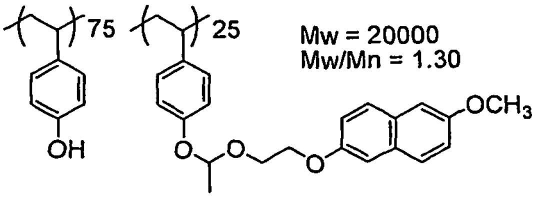

Mw = 20000
Mw/Mn = 1.30

(B-9)

Mw = 13000
Mw/Mn = 1.12

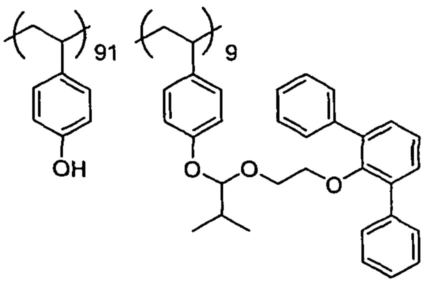

(B-10)

Mw = 11000
Mw/Mn = 1.91

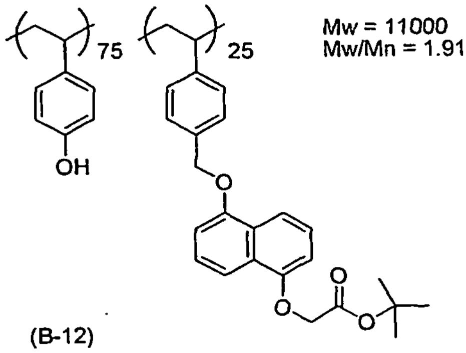

(B-11)

Mw = 10000
Mw/Mn = 1.65

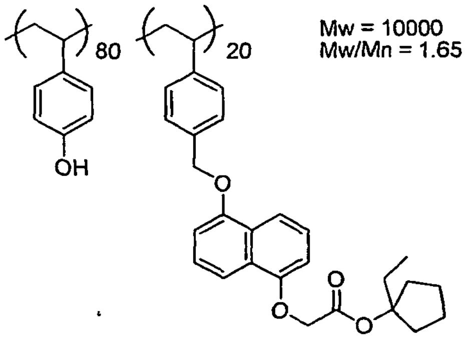

(B-12)

Mw = 8000
Mw/Mn = 1.45

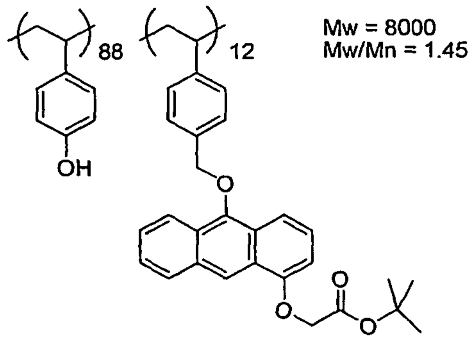

(B-13)

Mw = 20000
Mw/Mn = 1.55

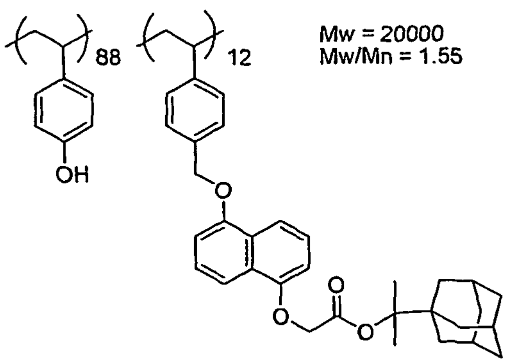

(b-1)

Mw =6000
Mw/Mn = 1.24

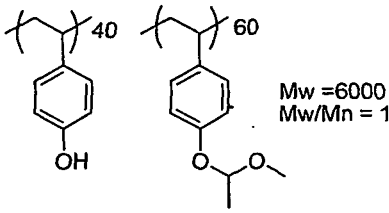

With respect to each of the above resins, the compound (HO-X) from which the residue (c) is derived exhibits the following Ip value. The Ip values were calculated using MOPAC (PM3 parameter) of software CAChe 4.1.1 available from Oxford Molecular, Inc. The Ip value of phenol calculated in the same manner as mentioned above is 9.175 eV. With respect to the comparative resin b-1, the moiety thereof corresponding to HO-X is $HO-CH_3$. Further, with respect to the resins (B-10) to (B-13), the moiety thereof corresponding to HO-X is respectively (B-10-X) to (B-13-X) below.

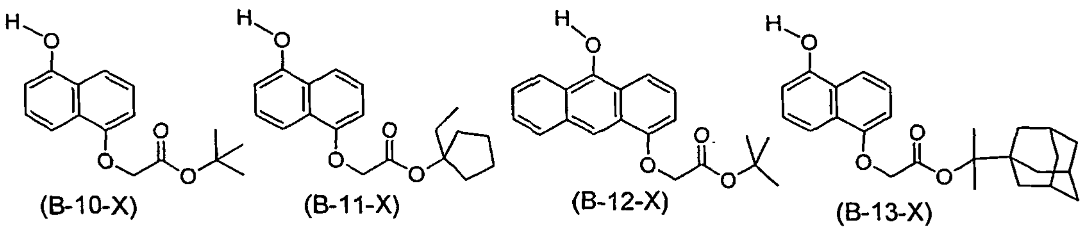

(B-10-X) (B-11-X) (B-12-X) (B-13-X)

Table 1

| Resin (B) | Ip value (eV) |
|---|---|
| Resin (B-1) | 8.477 |
| Resin(B-2) | 8.109 |
| Resin(B-3) | 8.935 |
| Resin(B-4) | 8.819 |
| Resin(B-5) | 8.015 |
| Resin (B-6) | 8.640 |
| Resin(B-7) | 8.935 |
| Resin(B-8) | 8.477 |
| Resin (B-9) | 8.935 |
| Resin(B-10) | 8.505 |
| Resin(B-11) | 8.504 |
| Resin(B-12) | 8.104 |
| Resin(B-13) | 8.505 |
| Resin(b-1) | 11.132 |

<Exposure evaluation>

[Examples 1 to 10, Examples 14-18 and Comparative Examples 1 to 3]

<Preparation of resist>

Referring to Table 2 below, the components were dissolved in solvents, thereby obtaining solutions of 2 mass% solid content. The thus obtained solutions were passed through a polyethylene filter of 0.05 μm pore size, thereby obtaining positive resist solutions. The thus obtained positive resist solutions were evaluated by the following methods. The results are given in Table 3 below.

<Evaluation of development residue after KrF exposure>

An organic antireflection film DUV 44 (produced by Nissan Chemical Industries, Ltd.) was applied onto a silicon wafer and baked at 205°C for 60 seconds, thereby forming a 60 nm-thick antireflection film. Each of the above prepared resist compositions was applied thereonto by spin coating and baked at 120°C for 90 seconds, thereby forming a 60 nm-thick resist film. The wafer having the resist film applied thereonto was patternwise exposed through an exposure mask by means of a KrF excimer laser scanner (manufactured by ASML, PAS5500/850, NA0.8). Thereafter, the exposed wafer was heated at 110°C for 90 seconds, developed using a 2.38 mass% aqueous solution of tetramethylammonium hydroxide at 23°C for 30 seconds, rinsed with pure water for 30 seconds, and dried, thereby obtaining a 100 nm line-and-space pattern for evaluation. The exposure intensity for obtaining the 100 nm line-and-space pattern for evaluation was established so as to be an exposure intensity appropriate for each of the resist compositions.

On the wafers produced by the above procedure, the number of development residues was counted using KLA-2360 manufactured by KLA-Tencor Corporation and Review SEM G3-FIB manufactured by KLA-Tencor Corporation. The development residue density is defined as the quotient of the measured number of development residues divided by the area of exposure (number/$cm^2$). The lower the density value, the higher the development residue performance. The results are given in Table 3.

[Outgassing performance in EB exposure: ratio of film thickness change by exposure]

Each of the above prepared resist compositions was applied onto a silicon wafer treated with hexamethyldisilazane by spin coating and baked at 120°C for 90 seconds, thereby forming a 60 nm-thick resist film. Thereafter, EB exposure of the resist film was carried out using an electron beam irradiator (50 keV accelerating voltage). Surface

exposure was carried out while changing the exposure intensity by 0.5 μC/cm$^2$ at a time within the range of 0 to 20.0 μC/cm$^2$, and the exposed film was baked at 110°C for 90 seconds. Thereafter, using a 2.38 mass% aqueous solution of tetramethylammonium hydroxide (TMAH), the film thickness at each of the exposure intensities was measured, thereby obtaining a sensitivity curve.

The sensitivity was defined as the exposure intensity at which the amount of remaining resist film was nil on the sensitivity curve.

Each resist film was exposed at the intensity of 2.0 times the intensity (μC/cm$^2$) at the sensitivity determined by performing the surface exposure by EB light, and the film thickness after exposure (prior to post-baking) was measured. The ratio of change from the film thickness before exposure was calculated according to the following formula.

Ratio of film thickness change (%) = [(film thickness before exposure - film thickness after exposure)/film thickness before exposure]×100.

[Outgassing performance in EUV exposure: ratio of film thickness change by exposure]

Each of the above prepared resist compositions was applied onto a silicon wafer treated with hexamethyldisilazane by spin coating and baked at 120°C for 90 seconds, thereby forming a 60 nm-thick resist film. Subsequently, using EUV light (13 nm wavelength), the surface exposure of the obtained resist film was carried out while changing the exposure intensity by 0.5 mJ/cm$^2$ at a time within the range of 0 to 20.0 mJ/cm$^2$, and the exposed film was baked at 110°C for 90 seconds. Thereafter, using a 2.38 mass% aqueous solution of tetramethylammonium hydroxide (TMAH), the film thickness at each of the exposure intensities was measured, thereby obtaining a sensitivity curve.

The sensitivity was defined as the exposure intensity at which the amount of remaining resist film was nil on the sensitivity curve.

Each resist film was exposed at the intensity of 2.0 times the intensity (mJ/cm$^2$) at the sensitivity determined by performing the surface exposure by EUV light, and the film thickness after exposure (prior to post-baking) was measured. The ratio of change from the film thickness before exposure was calculated according to the following formula.

Ratio of film thickness change (%) = [(film thickness before exposure - film thickness after exposure)/film thickness before exposure]×100.

Table 2

| | (A) Acid generator (mass part) | (B) Resin (mass part) | (E) Basic compound (mass part) | Solvent (mass ratio) | Surfactant (100ppm) |
|---|---|---|---|---|---|
| Ex.1 | A1-1 (18.0) | B-1 (80.2) | E-2 (1.80) | SL-1/SL-4 (80/20) | W-3 |
| Ex.2 | A1-2 (15.0) | B-2 (83.6) | E-2 (1.40) | SL-1/SL-4 (80/20) | W-3 |
| Ex.3 | A1-3 (12.0) | B-3 (86.8) | E-3 (1.20) | SL-1/SL-5 (20/80) | W-4 |
| Ex.4 | A1-4 (10.3) | B-4 (88.7) | E-4 (1.00) | SL-1/SL-4 (70/30) | W-1 |
| Ex.5 | A1-5 (7.5) | B-5 (91.8) | E-5 (0.75) | SL-1/SL-2 (60/40) | W-4 |
| Ex.6 | A1-6 (15.5) | B-5 (83.4) | E-1 (1.15) | SL-4/SL-6 (80/20) | W-3 |
| Ex.7 | A1-7 (11.5) | B-4 (87.5) | E-3 (0.98) | SL-1 | W-2 |
| Ex.8 | A1-8 (12.3) | B-3 (87.2) | E-2 (0.50) | SL-1/SL-3 (70/30) | W-2 |
| Ex.9 | A1-9 (21.3) | B-2 (77.3) | E-4 (1.45) | SL-1/SL-5 (70/30) | W-2 |
| Ex.10 | A1-10 (14.3) | B-1 (84.6) | E-2 (1.12) | SL-1/SL-4 (90/10) | W-3 |
| Ex.14 | A1-1 (7.8) | B-3 (91.7) | E-3 (0.46) | SL-1/SL-5 (80/20) | W-2 |
| Ex.15 | A1-4 (10.3) | B-6 (88.7) | E-4 (1.00) | SL-1/SL-4 (70/30) | W-1 |
| Ex.16 | A1-5 (7.5) | B-7 (91.8) | E-5 (0.75) | SL-1/SL-2 (60/40) | W-4 |
| Ex.17 | A1-6 (15.5) | B-8 (83.4) | E-1 (1.15) | SL-4/SL-6 (80/20) | W-3 |

(continued)

| | (A) Acid generator (mass part) | (B) Resin (mass part) | (E) Basic compound (mass part) | Solvent (mass ratio) | Surfactant (100ppm) |
|---|---|---|---|---|---|
| Ex.18 Ex. | A1-5 (7.5) | B-9 (91.8) | E-5 (0.75) | SL-1/SL-2 (60/40) | W-4 |
| comp.1 | A-11 (4.5) | b-1 (95.2) | E-1 (0.32) | SL-1 | W-4 |
| Comp.2 | Z (25.0) | B-5 (73.2) | E-1 (1.80) | SL-4 | W-1 |
| Comp.3 | Z (11.3) | b-1 (87.7) | E-1 (1.00) | SL-4 | W-1 |

Table 3

| | Development residue density (number/cm$^2$) | Ratio of film thickness change by EB exposure (%) | Ratio of film thickness change by EUV exposure (%) |
|---|---|---|---|
| Ex.1 | 0.75 | 8.5 | 7.7 |
| Ex.2 | 0.93 | 8.3 | 7.5 |
| Ex.3 | 0.15 | 4.5 | 8.5 |
| Ex.4 | 0.45 | 5.5 | 8.2 |
| Ex.5 | 0.92 | 9.2 | 4.7 |
| Ex.6 | 0.85 | 4.6 | 4.1 |
| Ex.7 | 0.56 | 6.2 | 9.0 |
| Ex.8 | 0.52 | 6.3 | 9.2 |
| Ex.9 | 0.75 | 8.3 | 7.5 |
| Ex.10 | 0.82 | 7.4 | 6.7 |
| Ex.14 | 0.24 | 3.5 | 3.2 |
| Ex.15 | 0.54 | 7.5 | 5.5 |
| Ex.16 | 0.62 | 3.2 | 8.5 |
| Ex.17 | 0.72 | 7.4 | 6.2 |
| Ex.18 | 0.82 | 2.5 | 7.2 |
| Comp.1 | 6.25 | 33.5 | 30.2 |
| Comp.2 | 54.5 | 14.5 | 13.1 |
| Comp.3 | 102.5 | 34.3 | 30.9 |

Besides the above, the following components were used.

[Basic compound]

E-1: 2,4,5-triphenylimidazole,
E-2: tetrabutylammonium hydroxide,
E-3: 1,5-diazabicyclo[4.3.0]non-5-ene,
E-4: tri-n-octylamine, and
E-5: 2-phenylbenzimidazole.

[Surfactant]

W-1: Megafac F176 (produced by Dainippon Ink & Chemicals, Inc.) (fluorinated),
W-2: Megafac R08 (produced by Dainippon Ink & Chemicals, Inc.) (fluorinated and siliconized),
W-3: polysiloxane polymer KP-341 (produced by Shin-Etsu Chemical Co., Ltd.) (siliconized), and
W-4: Troy Sol S-366 (produced by Troy Chemical Co., Ltd.).

[Solvent]

SL-1: propylene glycol monomethyl ether acetate,
SL-2: 2-heptanone,
SL-3: cyclohexanone,
SL-4: γ-butyrolactone,
SL-5: propylene glycol monomethyl ether, and
SL-6: ethyl lactate.

It is apparent from the results of Table 3 that the resist compositions of the present invention are superior to those of the Comparative Examples in both the development residue and outgassing performance.

## Claims

1. An actinic-ray- or radiation-sensitive resin composition comprising (A) an acid generator being a compound of General Formula (I) below, and (B) a resin which exhibits an increased solubility in an alkali developer when acted on by an acid and which contains a repeating unit (D) of general formula (II) below;

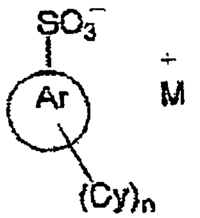

(I)

wherein
Ar represents an aromatic ring having Cy groups and optionally further other substituents,
n is an integer of 2 or more,
Cy represents a group having a substituted or unsubstituted cycloaliphatic group, provided that a plurality of Cy groups may be identical with or different from each other, and
$M^+$ represents an organic onium ion;

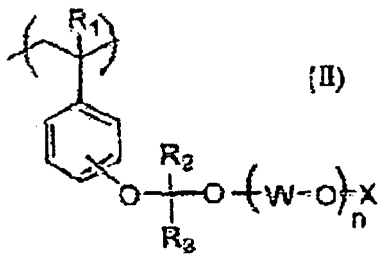

(II)

wherein

$R_1$ represents a hydrogen atom or a methyl group,
each of $R_2$ and $R_3$ independently represents a hydrogen atom, an alkyl group, a cycloalkyl group, an aryl group or an aralkyl group,
W represents a bivalent organic group,
n is an integer of 1 to 4, provided that when n is an integer of 2 to 4, a plurality of W groups may be identical with or different from each other, and
X represents -L-Y wherein L represents a single bond or an alkylene group, and Y is a group selected from

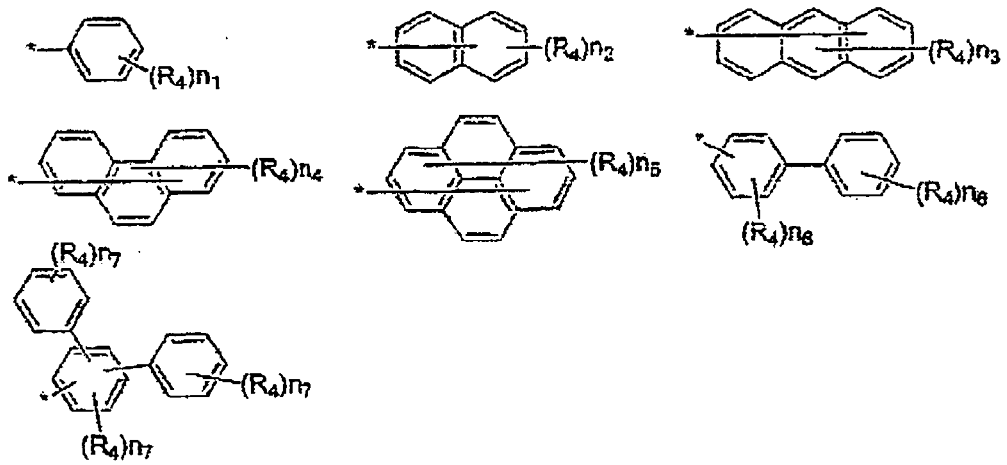

wherein
$R_4$ or each of $R_4$s independently represents a linear or branched alkyl group having 1 to 6 carbon atoms or an alkoxy group,
$n_1$ is an integer of 0 to 3, $n_2$ is an integer of 0 to 7, $n_3$ is an integer of 0 to 9, $n_4$ is an integer of 0 to 9, $n_5$ is an integer of 0 to 9, $n_6$ is an integer of 0 to 3 and $n_7$ is an integer of 0 to 3, and
* represents a site of connection with L;
the ionization potential of a compound of formula HO-L-Y being lower than that of phenol;
with the proviso that the resin (B) is not

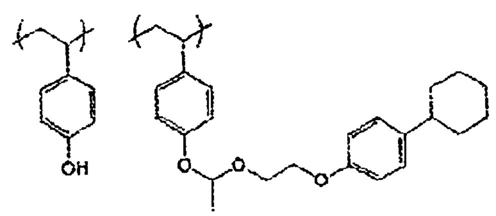

2. An actinic-ray- or radiation-sensitive resin composition according to Claim 1, wherein Ar in General Formula (I) represents a benzene ring and n is 3.

3. A method of forming a pattern comprising forming the actinic-ray- or radiation-sensitive resin composition according to Claim 1 into a film, exposing the film and developing the exposed film.

4. A pattern forming method according to Claim 3, wherein the exposure is carried out using X-rays, electron beams or EUV light.

**Patentansprüche**

1. Gegenüber aktinischen Strahlen oder Strahlung empfindliche Harzzusammensetzung, umfassend (A) einen Säurebildner, der eine Verbindung der nachstehenden allgemeinen Formel (I) ist, und (B) ein Harz, das eine erhöhte Löslichkeit in einem Alkalientwickler zeigt, wenn eine Säure hierauf einwirkt, und welches eine Wiederholungseinheit

(D) der nachstehenden Formel (II) enthält;

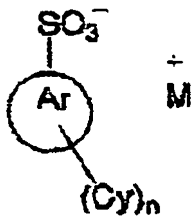

(I)

worin
Ar einen aromatischen Ring, der Cy-Gruppen aufweist und der ferner optional andere Substituenten aufweist, darstellt,
n eine ganze Zahl von 2 oder größer ist,
Cy eine Gruppe darstellt, die eine substituierte oder unsubstituierte cycloaliphatische Gruppe aufweist, vorausgesetzt, dass eine Vielzahl von Cy-Gruppen zueinander identisch oder verschieden sein können, und
$M^+$ ein organisches Oniumion darstellt;

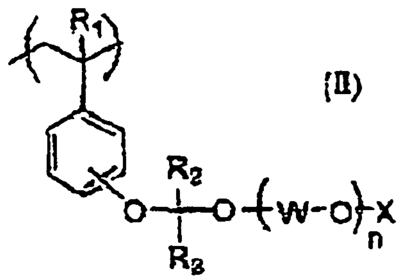

(II)

worin
$R_1$ ein Wasserstoffatom oder eine Methylgruppe darstellt, jedes von $R_2$ und $R_3$ unabhängig ein Wasserstoffatom, eine Alkylgruppe, eine Cycloalkylgruppe, eine Arylgruppe oder eine Aralkylgruppe darstellt,
W eine bivalente organische Gruppe darstellt,
n eine ganze Zahl von 1 bis 4 ist, vorausgesetzt, dass, wenn n eine ganze Zahl von 2 bis 4 ist, die Vielzahl von W-Gruppen zueinander identisch oder voneinander verschieden sein können und
X -L-Y darstellt, worin L eine Einfachbindung oder eine Alkylengruppe darstellt und Y eine Gruppe ist, die ausgewählt ist aus

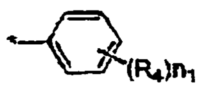 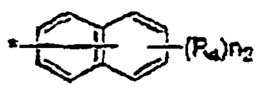 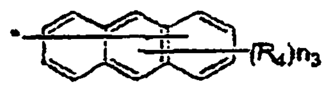

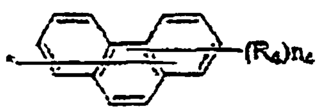 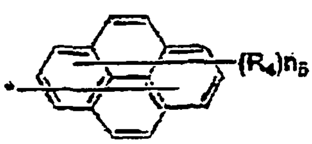 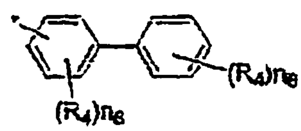

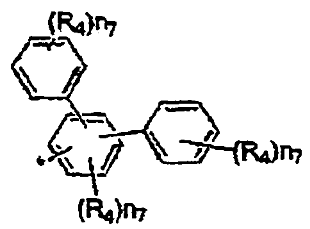

worin $R_4$ oder jedes der $R_4$ unabhängig eine lineare oder verzweigte Alkylgruppe mit 1 bis 6 Kohlenstoffatomen oder eine Alkoxygruppe darstellt,
$n_1$ eine ganze Zahl von 0 bis 3 ist, $n_2$ eine ganze Zahl von 0 bis 7 ist, $n_3$ eine ganze Zahl von 0 bis 9 ist, $n_4$ eine

ganze Zahl von 0 bis 9 ist, $n_5$ eine ganze Zahl von 0 bis 9 ist, $n_6$ eine ganze Zahl von 0 bis 3 ist und $n_7$ eine ganze Zahl von 0 bis 3 ist, und
* eine Verknüpfungsstelle mit L darstellt;
worin das Ionisierungspotential einer Verbindung der Formel HO-L-Y niedriger ist als das von Phenol;
vorausgesetzt, dass das Harz (B) nicht

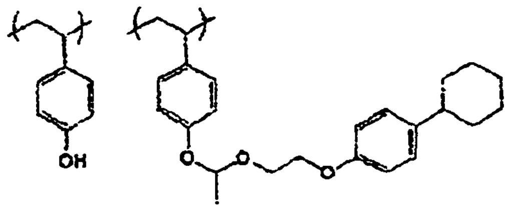

ist.

2. Gegenüber aktinischen Strahlen oder Strahlung empfindliche Harzzusammensetzung gemäß Anspruch 1, worin Ar in der allgemeinen Formel (I) einen Benzolring darstellt und n 3 ist.

3. Verfahren zum Bilden einer Struktur, umfassend das Formen der gegenüber aktinischen Strahlen oder Strahlung empfindlichen Harzzusammensetzung gemäß Anspruch 1 zu einem Film, Belichten des Films und Entwickeln des belichteten Films.

4. Strukturbildendes Verfahren gemäß Anspruch 3, worin die Belichtung unter Verwendung von Röntgenstrahlen, Elektronenstrahlen oder EUV-Licht durchgeführt wird.

## Revendications

1. Composition de résine sensible à un rayonnement ou aux rayons actiniques comprenant (A) un générateur d'acide étant un composé de la formule générale (I) ci-dessous, et (B) une résine qui présente une solubilité plus élevée dans un révélateur alcalin lorsqu'il est sollicité par un acide et qui contient une unité répétitive (D) de la formule générale (II) ci-dessous ;

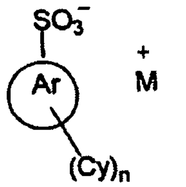

(I)

dans laquelle
Ar représente un cycle aromatique présentant des groupes Cy et éventuellement de plus d'autres substituants,
n est un nombre entier de 2 ou supérieur,
Cy représente un groupe présentant un groupe cycloaliphatique substitué ou non substitué, à condition que plusieurs groupes Cy peuvent être identiques ou différents les uns des autres, et
$M^+$ représente un ion onium organique ;

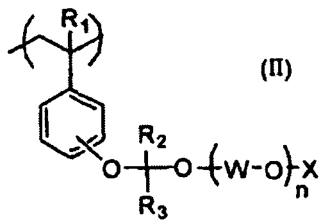

(II)

dans laquelle

$R_1$ représente un atome d'hydrogène ou un groupe méthyle, chacun de $R_2$ et $R_3$ représentent indépendamment un atome d'hydrogène, un groupe alkyle, un groupe cycloalkyle, un groupe aryle ou un groupe aralkyle,

W représente un groupe organique bivalent,

n est un nombre entier de 1 à 4, à condition que lorsque n est un nombre entier de 2 à 4, plusieurs groupes W peuvent être identiques ou différents les uns des autres, et

X représente -L-Y où L représente une liaison simple ou un groupe alkylène, et Y est un groupe choisi parmi

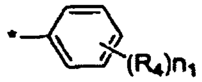
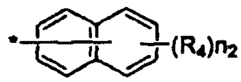
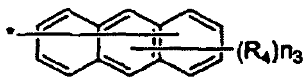
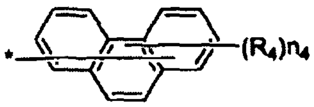
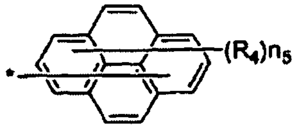
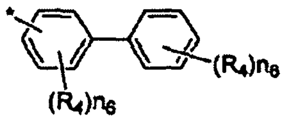
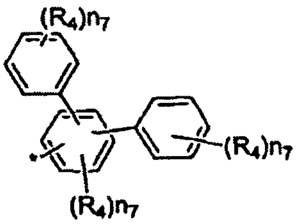

où

$R_4$ ou chacun des $R_4$ représentent indépendamment un groupe alkyle linéaire ou ramifié ayant de 1 à 6 atomes de carbone ou un groupe alcoxy,

$n_1$ est un nombre entier de 0 à 3, $n_2$ est un nombre entier de 0 à 7, $n_3$ est un nombre entier de 0 à 9, $n_4$ est un nombre entier de 0 à 9, $n_5$ est un nombre entier de 0 à 9, $n_6$ est un nombre entier de 0 à 3 et $n_7$ est un nombre entier de 0 à 3, et

* représente un site de connexion avec L ;

le potentiel d'ionisation d'un composé de la formule HO-L-Y étant inférieur à celui du phénol ;

à condition que la résine (B) ne soit pas

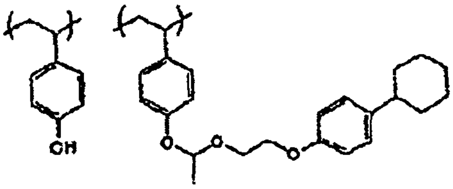

**2.** Composition de résine sensible à un rayonnement ou aux rayons actiniques selon la revendication 1, dans lequel Ar dans la formule générale (I) représente un cycle benzène et n est égal à 3.

**3.** Procédé de formation d'un motif comprenant la formation de la composition de résine sensible à un rayonnement ou aux rayons actiniques selon la revendication 1 en un film, l'exposition du film et le développement du film exposé.

**4.** Procédé de formation d'un motif selon la revendication 3, dans lequel l'exposition est réalisée en utilisant des rayons X, des faisceaux d'électrons ou de la lumière EUV.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010035905 A1
- EP 1536285 A
- JP 2008249890 A
- JP 2000267282 A
- JP H10282669 A
- US 6548221 B
- US 20070184384 A
- JP 6184170 A
- US 3849137 A
- DE 3914407
- JP S6326653 A
- JP 55164824 A
- JP 62069263 A
- JP 63146038 A
- JP 63163452 A
- JP 62153853 A
- JP 63146029 A
- US 3779778 A
- EP 126712 A
- JP 2008096951 A
- EP 254853 A
- JP AS2258500 B
- JP 3223860 A
- JP 4251259 A
- US 6040112 A
- US 20070224539 A1
- JP 2002363146 A
- JP 2007298569 A
- US 20080248425 A1
- JP S4122938 A
- JP 2028531 A
- US P4916210 A
- EP 219294 A


### Non-patent literature cited in the description


- **JAMES J.P. STEWART.** *Journal of Computer-Aided Molecular Design,* 1990, vol. 4 (1), 1-105